# EUROPEAN PATENT APPLICATION

(11) **EP 4 750 269 A1**
(43) Date of publication of application: **27.05.2026**
(21) Application number: 24843204.9
(22) Date of filing: 19.07.2024
(51) Int. Cl.: H10F 19/90

(54) **POWER GENERATION MODULE AND METHOD FOR MANUFACTURING POWER GENERATION MODULE**

(30) Priority: 19.07.2023 JP 2023117838; 19.07.2023 JP 2023117875
(71) Applicant: Panasonic Intellectual Property Management Co., Ltd., Kadoma-shi, Osaka 571-0057 (JP)
(72) Inventor: UCHIDA, Ryusuke, Kadoma-shi, Osaka 571-0057 (JP); MATSUI, Taisuke, Kadoma-shi, Osaka 571-0057 (JP); SHIRATAKI, Hiroshi, Kadoma-shi, Osaka 571-0057 (JP); HIGUCHI, Hiroshi, Kadoma-shi, Osaka 571-0057 (JP); KATAYAMA, Hirotaka, Kadoma-shi, Osaka 571-0057 (JP); HIRANO, Koichi, Kadoma-shi, Osaka 571-0057 (JP)
(74) Representative: Appelt, Christian W.
(86) International application number: PCT/JP2024/025985
(87) International publication number: WO 2025/018416

(57) **Abstract**

A power generation module that can be more easily manufactured to fit a desired shape and size, and a method for manufacturing the same is provided. The power generation module (1) according to the present disclosure includes a first substrate (10) having a light-transmitting property, a second substrate (20) having a light-transmitting property and facing the first substrate (10) in the thickness direction of the first substrate (10), and a plurality of submodules (30) positioned between the first substrate (10) and the second substrate (20), aligned in a direction intersecting the thickness direction. Each submodule (30) includes a base member (40) and a solar cell (50) disposed on the base member. The solar cell (50) includes a first electrode layer stacked on the base member (40), a semiconductor layer stacked on the first electrode layer, and a second electrode layer stacked on the semiconductor layer.

## Description

### TECHNICAL FIELD

The present disclosure relates to a power generation module used in building integrated photovoltaics (BIPV) and a manufacturing method thereof.

### BACKGROUND ART

Conventionally, as for this type of power generation module, for example, the one described in Patent Document 1 is known. The power generation module (window) described in Patent Document 1 includes a first substrate, solar cells supported by the first substrate, and a second substrate facing the first substrate via the solar cells. The first substrate has one main surface that supports the solar cells and the other main surface that constitutes the exterior surface of the window. The solar cell includes a transparent conductive layer formed directly on the one main surface of the first substrate, a semiconductor layer stacked on the transparent conductive layer, and a conductive layer stacked on the semiconductor layer.

### PRIOR ART DOCUMENT

### PATENT DOCUMENT

Patent Document 1: JP7187284B

### SUMMARY OF INVENTION

### TECHNICAL PROBLEM

The power generation module of Patent Document 1 still has room for improvement in terms of the difficulty of manufacturing power generation modules of various shapes and sizes.

It is therefore an object of the present disclosure to solve the above problem and to provide a power generation module that can be more easily manufactured to fit a desired shape and size.

### MEANS FOR SOLVING PROBLEM

A power generation module according to the present disclosure includes: a first substrate having a light-transmitting property; a second substrate having a light-transmitting property, the second substrate facing the first substrate in a thickness direction of the first substrate; and a plurality of submodules positioned side by side in a direction intersecting the thickness direction between the first substrate and the second substrate. Each submodule has a base member and a solar cell disposed on the base member. The solar cell has a first electrode layer stacked on the base member, a semiconductor layer stacked on the first electrode layer, and a second electrode layer stacked on the semiconductor layer.

A method for manufacturing a power generation module according to the present disclosure includes: preparing a first substrate and a second substrate, each of the first substrate and the second substrate having a light-transmitting property; preparing a plurality of submodules each having a base member and a solar cell disposed on the base member; arranging the plurality of submodules side by side on the first substrate in a direction intersecting a thickness direction of the first substrate; and disposing the second substrate facing the first substrate in the thickness direction, the plurality of submodules being positioned between the second substrate and the first substrate. The solar cell has a first electrode layer stacked on the base member, a semiconductor layer stacked on the first electrode layer, and a second electrode layer stacked on the semiconductor layer.

A power generation module according to the present disclosure includes: a first substrate having a light-transmitting property; a second substrate having a light-transmitting property, the second substrate facing the first substrate in a thickness direction of the first substrate; and a first submodule and a second submodule positioned side by side in a first direction intersecting the thickness direction between the first substrate and the second substrate. Each of the first and second submodules has a base member and a solar cell disposed on the base member. The solar cell has a first electrode layer stacked on the base member, a semiconductor layer stacked on the first electrode layer, and a second electrode layer stacked on the semiconductor layer. The first submodule and the second submodule have different dimensions in at least one of the first direction or a second direction intersecting both the thickness direction and the first direction.

A method for manufacturing a power generation module according to the present disclosure includes: preparing a plurality of submodules including a first submodule having a light-transmitting property and a second submodule having a light-transmitting property; preparing a first substrate having a light-transmitting property and one main surface including an arrangement region where the plurality of submodules are arranged and a non-arrangement region where the plurality of submodules are absent; preparing a second substrate having a light-transmitting property; arranging the first submodule and the second submodule side by side in a first direction intersecting a thickness direction of the first substrate in the arrangement region, the second submodule having different dimensions in at least one of the first direction or a second direction intersecting both the thickness direction and the first direction; and disposing the second substrate facing the first substrate in the thickness direction, the first submodule and the second submodule being positioned between the second substrate and the first substrate. Each of the plurality of submodules has a base member and a solar cell disposed on the base member. The solar cell has a first electrode layer stacked on the base member, a semiconductor layer stacked on the first electrode layer, and a second electrode layer stacked on the semiconductor layer.

A method for manufacturing a power generation module according to the present disclosure includes: preparing a first substrate having a light-transmitting property and an L-shape or a T-shape; preparing a second substrate having a light-transmitting property; preparing a first submodule and a second submodule, each of the first submodule and the second submodule having a base member and a solar cell disposed on the base member; arranging the first submodule and the second submodule densely on one main surface of the first substrate, the first submodule and the second submodule being aligned in a first direction intersecting a thickness direction of the first substrate, the second submodule having different dimensions in at least one of the first direction or a second direction intersecting both the thickness direction and the first direction; and disposing the second substrate facing first substrate in the thickness direction, the first submodule and the second submodule being positioned between the second substrate and the first substrate. The solar cell has a first electrode layer stacked on the base member, a semiconductor layer stacked on the first electrode layer, and a second electrode layer stacked on the semiconductor layer.

### ADVANTAGEOUS EFFECT OF INVENTION

According to the present disclosure, it is possible to provide a power generation module that can be more easily manufactured to fit a desired shape and size.

### BRIEF DESCRIPTION OF DRAWINGS

Fig. 1 is a plan view of a power generation module according to a first embodiment of the present disclosure.
Fig. 2 is a cross-sectional view taken along line II-II in Fig. 1.
Fig. 3 is a cross-sectional view taken along line III-III in Fig. 1.
Fig. 4 is a cross-sectional view of a lead wire disposed in the power generation module of Fig. 1.
Fig. 5 is a plan view of a power generation module according to a second embodiment of the present disclosure.
Fig. 6 is a cross-sectional view taken along line IV-IV in Fig. 5.
Fig. 7 is a plan view of a power generation module according to a third embodiment of the present disclosure.
Fig. 8 is a cross-sectional view taken along line VIII-VIII in Fig. 7.
Fig. 9 is a plan view of a power generation module according to a variant of the third embodiment of the present disclosure.
Fig. 10 is a plan view of a power generation module according to a fourth embodiment of the present disclosure.
Fig. 11 is a plan view of a power generation module according to a fifth embodiment of the present disclosure.
Fig. 12A is a schematic process perspective view showing a film formation step in a submodule manufacturing method.
Fig. 12B is a schematic process perspective view showing a film formation step in the submodule manufacturing method.
Fig. 12C is a schematic process perspective view showing a film processing process in the submodule manufacturing method.
Fig. 12D is a schematic cross-sectional view showing a film processing process in the submodule manufacturing method.
Fig. 13A is a schematic cross-sectional view showing a film processing process in the submodule manufacturing method.
Fig. 13B is a schematic cross-sectional view showing a film processing process in the submodule manufacturing method.
Fig. 13C is a schematic cross-sectional view showing a film processing process in the submodule manufacturing method.
Fig. 14 is a schematic top view showing a wiring formation step in the submodule manufacturing method.
Fig. 15 is a flowchart showing an example of a method for designing a power generation module according to the present disclosure.
Fig. 16 is a plan view of a power generation module according to a variant of the second embodiment of the present disclosure.

### DESCRIPTION OF EMBODIMENTS

### (Finding that Forms Basis of This Disclosure)

In conventional power generation modules, solar cells are directly mounted on a surface of a first substrate opposite a surface that constitutes the exterior surface of the window. Hence, the solar cells need to be designed for each shape and size of the first substrate. Furthermore, since first substrates of various shapes and sizes have to be handled during the solar cell formation process, a high difficulty lies in manufacturing the power generation modules. Therefore, there is a problem that it is difficult to increase the variation of sizes and shapes of the power generation modules.

Thus, the inventors conducted intensive research to provide a power generation module that can be more easily manufactured to fit desired shapes and sizes, and as a result, came up with a configuration of the power generation module that includes plural modules, each having a solar cell mounted on a base member. With this configuration, power generation modules of various shapes and sizes can be more easily manufactured by arranging a plurality of sub-modules in various patterns. Based on this novel finding, the inventors have arrived at the following disclosure.

Hereinafter, embodiments of the present disclosure will be described with reference to the drawings. In the following description, terms indicating specific directions or positions (e.g., terms including "up," "down," "right," and "left") will be used as necessary. However, the use of these terms is intended to facilitate understanding of the present disclosure with reference to the drawings, and the meanings of these terms do not limit the technical scope of the present disclosure or the manner of use of the power generation module according to the present disclosure. Furthermore, the following description is merely exemplary in nature and is not intended to limit the present disclosure, its applications, or its uses. Furthermore, the drawings are schematic, and the proportions of the dimensions do not necessarily correspond to the actual ones.

In this description, "electrically connected" may mean at least one of the following: current can be conducted between plural components; plural components are capacitively coupled; and plural components are electromagnetically coupled.

### (First Embodiment)

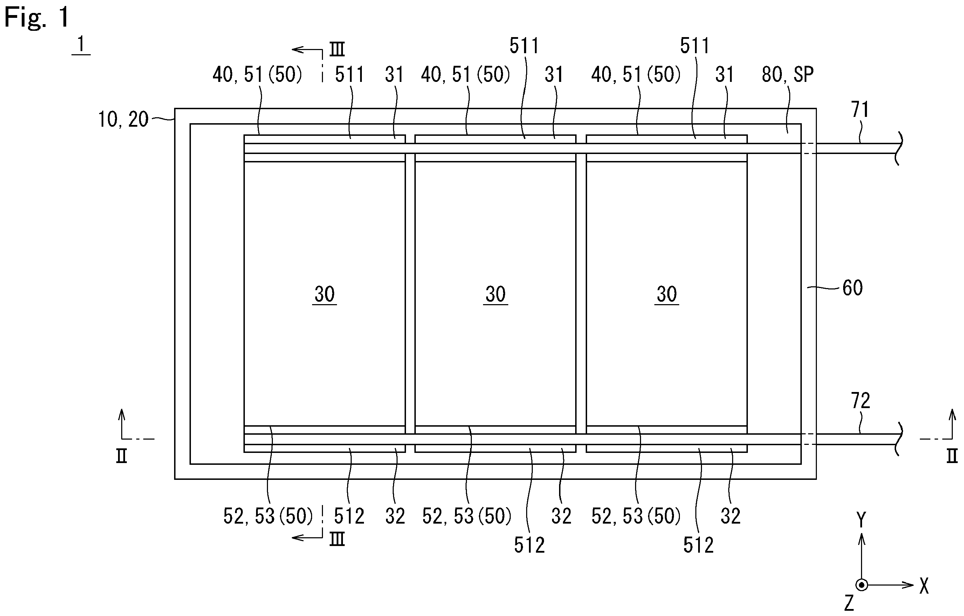

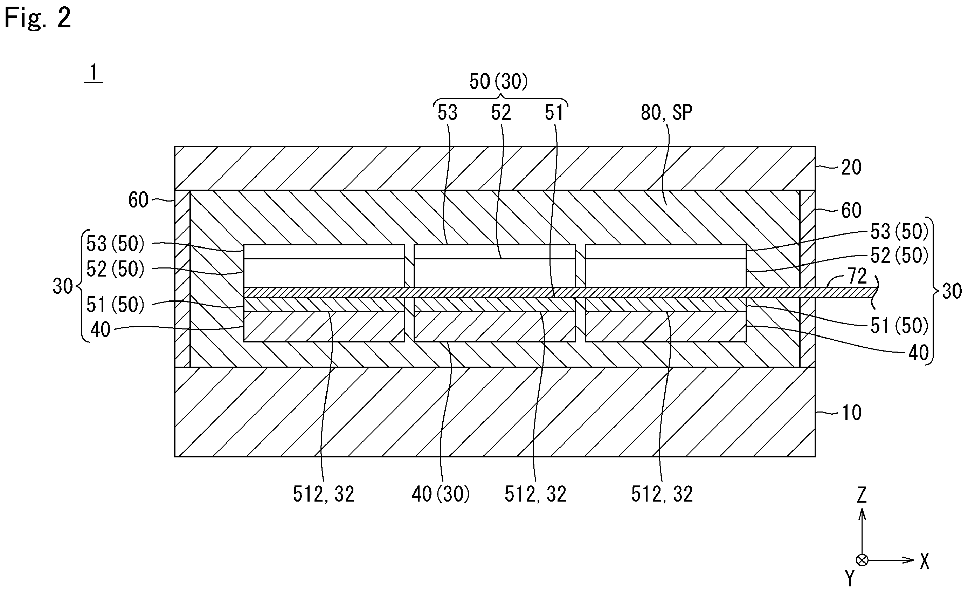

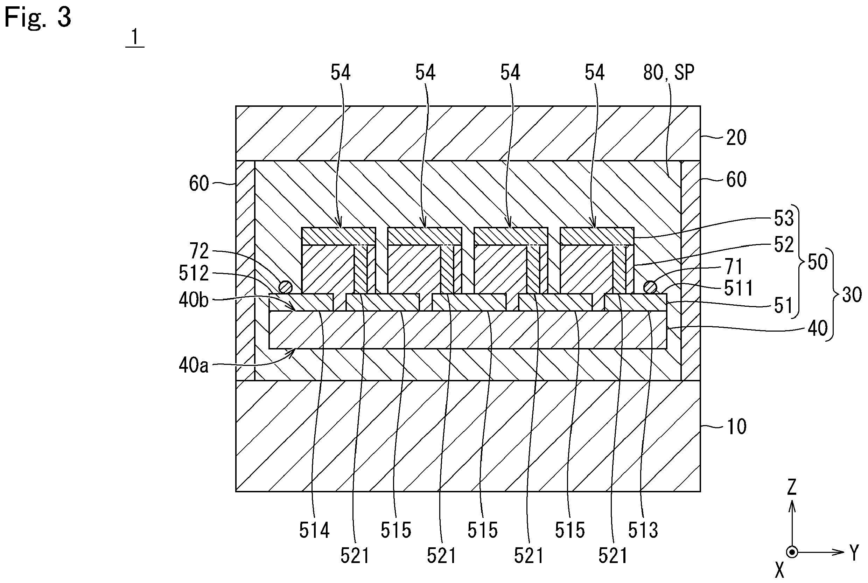

A power generation module according to a first embodiment of the present disclosure will be described with reference to Figs. 1 to 3. Fig. 1 is a plan view of the power generation module according to the first embodiment of the present disclosure. Fig. 2 is a cross-sectional view taken along line II-II in Fig. 1. Fig. 3 is a cross-sectional view taken along line III-III in Fig. 1. For convenience of explanation, an X-Y-Z Cartesian coordinate system is shown in the drawings, but this coordinate system is intended to facilitate understanding of the present disclosure and does not limit the present disclosure.

In Fig. 2, a semiconductor layer 52 and a second electrode layer 53 located at the back of the page are visible through a transparent filler 80. In Fig. 2, the hatching of the filler 80 is omitted in the regions of the semiconductor layer 52 and the second electrode layer 53.

A power generation module 1 is a module used in building integrated photovoltaics (BIPV). The power generation module 1 also functions as a building material such as a roof, wall, or window. The building material constitutes at least a part of, for example, a building or a vehicle. In this embodiment and a second embodiment described below, an example will be described in which the power generation module 1 is integrated with a window.

As shown in Figs. 1 to 3, the power generation module 1 includes a first substrate 10 and a second substrate 20. As shown in Figs. 2 and 3, the first substrate 10 and the second substrate 20 are disposed facing each other in the thickness direction of the first substrate 10, i.e., in the thickness direction of the power generation module 1.

In the following description, the thickness direction of the power generation module 1 will be simply referred to as the "thickness direction" or the Z direction. One of the directions intersecting the thickness direction will be referred to as the X direction, and the direction intersecting both the X and Z directions will be referred to as the Y direction. In the Z direction, the direction from the first substrate 10 to the second substrate 20 will be referred to as the upward direction, and the direction from the second substrate 20 to the first substrate 10 will be referred to as the downward direction.

As shown in Figs. 1 and 2, a plurality of submodules 30 are disposed between the first substrate 10 and the second substrate 20. As shown in Fig. 2, each submodule 30 has a sheet-like base member 40 and a solar cell 50 disposed on the base member 40. The base member 40 is formed in a plate shape and is a member that supports the solar cell 50. The solar cell 50 is configured to receive light from outside the power generation module 1 and generate electricity.

As shown in Fig. 1, the solar cells 50 are connected between the plurality of submodules 30 by a first lead wire 71 and a second lead wire 72.

A sealing member 60 that seals the gap is disposed in the gap between the first substrate 10 and the second substrate 20. The sealing member 60 has an annular shape that surrounds the plurality of submodules 30 in a plan view seen along the Z direction.

As shown in Fig. 2, the first substrate 10, the second substrate 20, and the sealing member 60 define an internal space SP of the power generation module 1. The internal space SP is a space that houses the plurality of submodules 30. In this embodiment, the internal space SP is filled with the filler 80.

The first substrate 10 and the second substrate 20 are base materials that make up the outer casing of the power generation module 1. The first substrate 10 and the second substrate 20 are made of a material that has low moisture and gas permeability so as to suppress deterioration of the components housed in the internal space SP due to moisture and gas. The material of the first substrate 10 and the second substrate 20 is, for example, resin, glass, etc.

In this embodiment, the first substrate 10 and the second substrate 20 are both made of a transparent glass plate and have a light-transmitting property.

The shapes of the first substrate 10 and the second substrate 20 in plan view may vary depending on the design of the building or the like in which the power generation module 1 is used as a building material. In this embodiment, the first substrate 10 and the second substrate 20 are formed in a rectangular shape having sides extending in the X direction and the Y direction in plan view (see Fig. 1), and have the same or substantially the same dimensions. In this embodiment, the dimension of the first substrate 10 and the second substrate 20 in the X direction is larger than the dimension in the Y direction.

As shown in Fig. 1, the power generation module 1 includes three submodules 30. The submodules 30 are juxtaposed in a direction intersecting the Z direction. In this embodiment, the submodules 30 are aligned in a row along the X direction in plan view. The X direction is an example of an "alignment direction" in the present disclosure.

Each submodule 30 has a first end 31 in the Y direction and a second end 32 that is the end opposite to the first end 31. The Y direction is an example of the "transverse direction" in this disclosure.

In this embodiment, each submodule 30 has a rectangular shape with sides extending in the X direction and sides extending in the Y direction in plan view, so the first end 31 and the second end 32 can also be considered as edges extending in the X direction.

The base member 40 has a lower surface 40a and an upper surface 40b. The lower surface 40a faces the first substrate 10 via the filler 80, and the upper surface 40b directly supports the solar cell 50. In this embodiment, the base member 40 is located apart from the first substrate 10.

The base member 40 is made of a material that is resistant to deformation due to heat applied when soldering the lead wires 71, 72 to the solar cell 50. For example, the base member 40 is made of a material such as glass or a heat-resistant resin. In this embodiment, the base member 40 is a transparent glass plate.

There are no particular limitations on the shape of the base member 40 in plan view. In this embodiment, the base member 40 is rectangular in plan view (see Fig. 1) having sides extending in the X direction and Y direction.

The solar cell 50 has a layered structure in which a first electrode layer 51, the semiconductor layer 52, and the second electrode layer 53 are stacked. The first electrode layer 51 is disposed in contact with the upper surface 40b of the base member 40. The semiconductor layer 52 is located on the first electrode layer 51. The second electrode layer 53 is located on the semiconductor layer 52.

The semiconductor layer 52 has a function of converting light energy into electrical energy. The first electrode layer 51 and the second electrode layer 53 are electrically connected to the semiconductor layer 52. The second electrode layer 53 has a light-transmitting property so that light incident on the power generation module 1 along the Z direction can reach the semiconductor layer 52.

As shown in Fig. 1, the dimensions of the semiconductor layer 52 and the second electrode layer 53 in the Y direction are smaller than the dimensions of the base member 40 and the first electrode layer 51 in the Y direction.

The first electrode layer 51 has a first extension 511 and a second extension 512 that protrude from the semiconductor layer 52 in the Y direction in plan view. The first extension 511 is a region of the first electrode layer 51 that protrudes in the +Y direction from the semiconductor layer 52, and is included in the first end 31. The second extension 512 is a region of the first electrode layer 51 that protrudes in the -Y direction from the semiconductor layer 52, and is included in the second end portion 32. In this embodiment, each of the extensions 511, 512 has a strip shape that extends along the X direction in plan view.

As shown in Figs. 1 and 2, the first extensions 511 of the plural submodules 30 are connected to each other by the first lead wire 71. The second extensions 512 of the plural submodules 30 are connected to each other by the second lead wire 72. Through these connections, the solar cells 50 are electrically connected in parallel among the three submodules 30. In this embodiment, the first lead wire 71 and the second lead wire 72 extend along the X direction.

In this embodiment, as shown in Fig. 2, the second lead wire 72 is connected to the second extension 512 over the entire length of the second extension 512 in the X direction. Similarly, the first lead wire 71 is connected to the first extension 511 over the entire length of the first extension 511 in the X direction.

As shown in Figs. 1 and 2, the lead wires 71, 72 extend in the X direction in the internal space SP, pass through the sealing member 60, and are drawn out to the outside of the power generation module 1. The lead wires 71, 72 may be connected, for example, to a controller (not shown) that controls power generation and distributes the generated power, or to a terminal disposed on a terminal box outside the power generation module 1. In this case, the lead wires 71, 72 function as wiring that extracts the power generated by the solar cell 50 to the outside of the power generation module 1.

For example, the first lead wire 71 is connected to each of the three first extensions 511 after the three submodules 30 are arranged above the first substrate 10. In this case, the first lead wire 71 may be configured as a single lead wire. That is, when the first lead wire 71 is disposed, one long lead wire may be arranged across the first extensions 511 of the three submodules 30.

Alternatively, a plurality of lead wires may be connected to the first lead wire 71. In this case, for example, in the manufacturing process of each submodule 30, a lead wire constituting a part of the first lead wire 71 may be connected in advance to each first extension 511. Thereafter, in the process of arranging three submodules 30 above the first substrate 10, the lead wires disposed on adjacent first extensions 511 may be solder-connected to each other to form the first lead wire 71.

Similar to the first lead wire 71 described above, the second lead wire 72 may be made up of a single lead wire or may be made up of a plurality of connected lead wires.

The connection between each of the lead wires 71, 72 and each of the extensions 511, 512 is made by, for example, soldering or applying a metal paste.

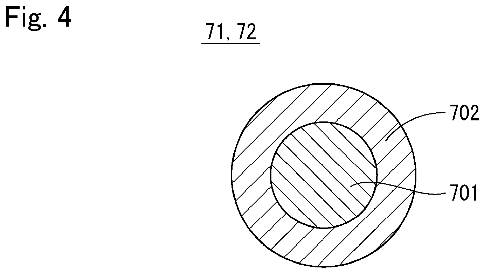

Fig. 4 is a cross-sectional view of a lead wire disposed in the power generation module of Fig. 1. Each of the lead wires 71, 72 is electrically conductive. In this embodiment, as shown in Fig. 4, each of the lead wires 71, 72 has a copper wire 701 and a solder layer 702 that covers the copper wire 701. The solder layer 702 constitutes the outermost layer of each of the lead wires 71, 72.

The solder layer 702 suppresses formation of rust on the copper wire 701. When the lead wires 71, 72 are soldered to the first electrode layer 51, the solder layer 702 functions as a pre-solder.

As shown in Fig. 3, the solar cell 50 has four solar cell elements 54 arranged in the Y direction.

The semiconductor layer 52 and the second electrode layer 53 are separated for each solar cell element 54. In Fig. 1, separations of the semiconductor layer 52 and the second electrode layer 53 are not shown.

As shown in Fig. 3, the first electrode layer 51 has a plurality of separated portions 513, 514, 515 that are separated from one another in the Y direction.

Of the plural separated portions 513, 514, 515, the first separated portion 513 is located at one end in the Y direction and has the first extension 511, and the second separated portion 514 is located at the other end in the Y direction and has the second extension 512. A plurality of third separated portions 515 are disposed between the first separated portion 513 and the second separated portion 514, and each third separated portion 515 is disposed across two adjacent solar cell elements 54.

The first separated portion 513 and the three third separated portions 515 each constitute a positive electrode of a corresponding solar cell element 54. The portions of the second electrode layer 53 separated in the Y direction each constitute a negative electrode of a corresponding solar cell element 54.

In order to electrically connect the first separated portion 513 or the third separated portion 515 of the positive electrode to the second electrode layer 53 of the negative electrode, each solar cell element 54 includes a conductive member 521 that penetrates the semiconductor layer 52. In this embodiment, the conductive member 521 is formed integrally with the second electrode layer 53.

In the solar cell 50 described above, the four solar cell elements 54 are electrically connected in series between the first extension 511 and the second extension 512.

The first electrode layer 51 is formed on the upper surface 40b of the base member 40 by a known method, such as vapor deposition, sputtering, spin coating, or inkjet printing. Because the first electrode layer 51 is formed on the upper surface 40b of the base member 40 rather than on the surface of the first substrate 10, there is no need to design the solar cell 50 to fit the shape and size of the first substrate 10. Also, by changing the arrangement of the submodules 30, it is possible to implement power generation modules 1 of various shapes and sizes more easily than before. Furthermore, since there is no need to handle first substrates 10 of various shapes and sizes in the process of forming the submodules 30, manufacturing the power generation module 1 is easier than before.

Stacking of the semiconductor layer 52 on the first electrode layer 51 and stacking of the second electrode layer 53 on the semiconductor layer 52 may be performed by a known method such as the method exemplified as the method for forming the first electrode layer 51.

The first electrode layer 51 is formed, for example, over the entire upper surface 40b of the base member 40, and then unnecessary portions are removed by laser processing or the like, so that the first electrode layer 51 is stacked only in desired regions of the upper surface 40b. Alternatively, the first electrode layer 51 may be stacked only in desired regions of the upper surface 40b from the beginning. The semiconductor layer 52 and the second electrode layer 53 may also be formed into desired shapes by any of the methods described above.

The first electrode layer 51 and the second electrode layer 53 are transparent electrodes containing, for example, fluorine-doped tin oxide (FTO), indium oxide (ITO), indium zinc oxide (IZO), tin oxide, zinc oxide, aluminum zinc oxide (AZO), or the like. In this embodiment, the first electrode layer 51 is a transparent electrode containing fluorine-doped tin oxide, and the second electrode layer 53 is a transparent electrode containing indium oxide. Because both the first electrode layer 51 and the second electrode layer 53 are transparent electrodes, light for power generation can be incident on the semiconductor layer 52 through the first substrate 10 and the first electrode layer 51, or through the second substrate 20 and the second electrode layer 53.

The semiconductor layer 52 includes, for example, single crystal silicon, polycrystalline silicon, amorphous silicon, microcrystalline silicon, a compound semiconductor, an organic semiconductor, etc. In this embodiment, the semiconductor layer 52 has a layered structure in which a p-type semiconductor, an intrinsic semiconductor including perovskite crystals (perovskite material), and an n-type semiconductor are stacked. Furthermore, the semiconductor layer 52 may further include layers for protecting these semiconductors and transporting charges or holes.

The sealing member 60 suppresses entrance of moisture and gas into the internal space SP from the outside of the power generation module 1. In this embodiment, the sealing member 60 is disposed along the edge of each of the first substrate 10 and the second substrate 20 in plan view. For example, the sealing member 60 is made of a material such as rubber or resin. In this embodiment, the sealing member 60 is made of butyl rubber.

For example, the sealing member 60 may be placed on the first substrate 10 before the second substrate 20 is stacked on top of the first substrate 10, or may be placed in the gap between the first substrate 10 and the second substrate 20 after the second substrate 20 is stacked on top of the first substrate 10.

As shown in Figs. 2 and 3, the filler 80 fills the internal space SP so as to fill the entire space except for the three submodules 30 and the lead wires 71, 72, and seals the submodules 30 and the lead wires 71, 72 at their portions facing the internal space SP. For example, the filler 80 is made of a resin such as polyvinyl butyral (PVB) or ethylene-vinyl acetate copolymer (EVA). In this embodiment, the filler 80 is made of polyolefin (PO) and is transparent. This allows light to enter the solar cell 50, even though the filler 80 is disposed between the second substrate 20 and the solar cell 50 in the Z direction.

In one example of a manufacturing process for the power generation module 1, the filler 80 is formed into a sheet shape in advance and placed between the first substrate 10 and the submodule 30, and between the submodule 30 and the second substrate 20. The power generation module 1 is then heated, and the first substrate 10 and the second substrate 20 are pressed together in the Z direction. At this time, two sheet-shaped fillers 80 melt due to the heat and flow into the sides of the submodule 30. As a result, the internal space SP is filled with the filler 80.

The power generation module 1 described above includes the plurality of submodules 30 arranged in a direction intersecting the Z direction, and therefore, by changing the arrangement of the submodules 30, it is possible to more easily implement power generation modules 1 of various shapes and sizes than before. For example, it is possible to more easily implement the power generation module 1 that fits the shape and size of a building or the like.

In the case where both the first substrate 10 and the second substrate 20 are light-transmissive, light can pass through the power generation module 1 at least in the portion where no submodule 30 is disposed. This allows the power generation module 1 to be used as a window. Furthermore, when the first substrate 10 and the second substrate 20 are transparent, it is possible to see from one side of the power generation module 1 to the other. When the power generation module 1 is used as a window separating the outdoors from the indoors, it is preferable that the power generation module 1 be installed with the first substrate 10 facing the outdoors and the second substrate 20 facing the indoors. This separates the semiconductor layer 52 from the outdoors via the first substrate 10 and the base member 40, thereby suppressing deterioration and damage of the semiconductor layer 52 due to changes in the outdoor environment or impacts compared to when the power generation module 1 is installed with the second substrate 20 facing the outdoors.

Furthermore, according to the above power generation module 1, in the manufacturing process of the power generation module 1, the manufacturing process of the submodule 30, including the formation of the solar cell 50, and the process of arranging the submodule 30 between the first substrate 10 and the second substrate 20, can be performed in different locations. In other words, in the manufacturing process of the submodule 30, there is no need to handle first substrates 10 of various shapes and sizes. This increases the degree of freedom in the manufacturing process of the power generation module 1.

Furthermore, according to the power generation module 1 described above, the solar cell 50 is disposed on the base member 40, not on the first substrate 10. If a defect is found in the solar cell 50 during the manufacturing process, in a configuration in which the solar cell 50 is disposed on the first substrate 10, the entire solar cell 50 and the first substrate 10 would have to be discarded. On the other hand, according to the power generation module 1, it is only necessary to discard the submodule 30 that includes a solar cell 50 in which the defect is found. This makes it possible to improve the yield in manufacturing the power generation module 1.

Furthermore, according to the power generation module 1 described above, the solar cell 50 is not disposed on the first substrate 10, so that a material that is not suitable for forming the solar cell 50 can be used as the material for the first substrate 10. In other words, the number of materials that can be used for the first substrate 10 increases. This makes it possible to, for example, enhance the design quality of the power generation module 1 and improve the sealing performance of the internal space SP of the power generation module 1.

According to the above power generation module 1, the solar cells 50 disposed in the submodules 30 are electrically connected in parallel. Hence, even if the solar cells 50 of some of the submodules 30 malfunction, the solar cells 50 of the other submodules 30 can continue to generate power.

Furthermore, according to the power generation module 1 described above, the lead wires 71, 72 are connected to the first electrode layer 51 or the second electrode layer 53 at the first end 31 or the second end 32 of each of the submodules 30 that are aligned in a row in plan view. As a result, the lead wires 71, 72 connecting the solar cell 50 of each submodule 30 are not located in the center of the region where the plural submodules 30 are arranged in plan view, and are less noticeable when the power generation module 1 is viewed from the Z direction. Therefore, even in the power generation module 1 that includes lead wires 71, 72 connecting the plural solar cell cells 50, the design quality of the power generation module 1 as a building material can be improved.

For example, the first electrode layer 51 is formed on the base member 40 by a high-temperature process. On the other hand, the second electrode layer 53 is formed by a process that is lower in temperature than the method for forming the first electrode layer 51, in order to prevent the semiconductor layer adjacent to it in the Z direction from being deteriorated by heat. In this case, the electrical resistance of the first electrode layer 51 tends to be smaller than the electrical resistance of the second electrode layer 53.

According to the power generation module 1 described above, the lead wires 71, 72 connect the first electrode layers 51 to one another, which have lower electrical resistance than the second electrode layers 53. This improves the efficiency of extracting the power generated by each solar cell 50.

Furthermore, for example, when the lead wires 71, 72 are soldered to the second electrode layer 53, the heat for melting the solder may be conducted to the semiconductor layer 52 located below the second electrode layer 53, possibly deteriorating the semiconductor layer 52. On the other hand, when the lead wires 71, 72 are soldered to the first electrode layer 51, the heat is not easily conducted to the semiconductor layer 52, and therefore, deterioration of the semiconductor layer 52 due to heat can be suppressed.

If the semiconductor layer 52 deforms due to aging or the like after the power generation module 1 is installed, the position in the Z direction of the second electrode layer 53 stacked on the semiconductor layer 52 may drop. In a configuration in which the lead wires 71, 72 are connected to the second electrode layer 53, the drop in the position of the second electrode layer 53 may cause stress to be applied to the connection between the lead wires 71, 72 and the second electrode layer 53, which may result in disconnection.

On the other hand, in the power generation module 1 described above, the first electrode layer 51 to which the lead wires 71, 72 are connected is located below the semiconductor layer 52. Hence, the position of the first electrode layer 51 in the Z direction is less affected by deformation of the semiconductor layer 52. Thus, breaks in the connections between the lead wires 71, 72 and the solar cell 50 can be suppressed.

According to the power generation module 1 described above, the lead wires 71, 72 are connected to the first extension 511 or the second extension 512 of the first electrode layer 51. This makes the power generation module 1 even less noticeable when viewed from the Z direction, compared to a configuration in which the lead wires 71, 72 are connected to the first electrode layer 51 or the second electrode layer 53 at the first end 31 or the second end portion 32 of each submodule 30. Thus, even in the power generation module 1 including the lead wires 71, 72 connecting the plural solar cells 50, the design quality of the power generation module 1 as a building material can be further improved.

According to the power generation module 1 described above, the base member 40 is a glass plate, and therefore is less susceptible to deterioration due to heat than the semiconductor layer 52. Therefore, the first electrode layer 51, which has a lower electrical resistance than the second electrode layer 53, can be formed using a high-temperature process.

According to the power generation module 1 described above, the solder layer 702 constitutes the outermost layer of each of the lead wires 71, 72, so that each of the lead wires 71, 72 can be made thinner than a lead wire with an insulating coating.

### (Second Embodiment)

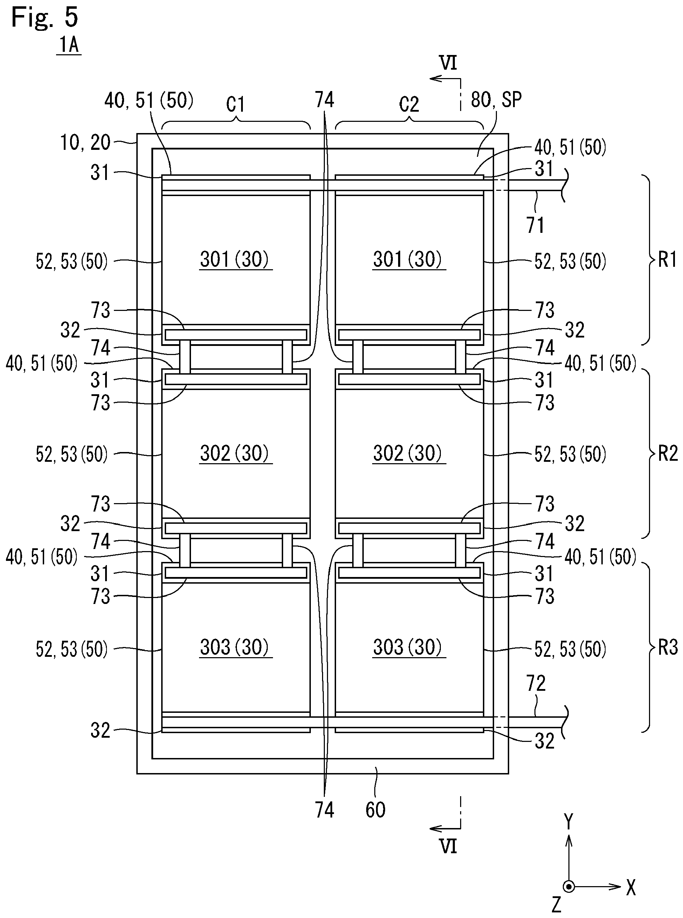

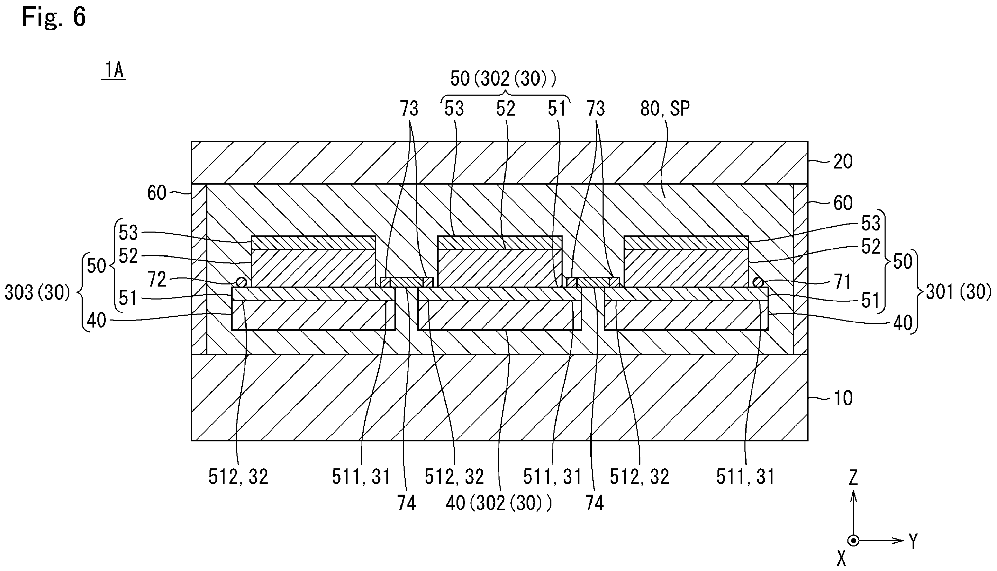

A power generation module 1A according to the second embodiment of the present disclosure will be described with reference to Figs. 5 and 6. Fig. 5 is a plan view of the power generation module according to the second embodiment of the present disclosure. Fig. 6 is a cross-sectional view taken along line IV-IV in Fig. 5.

The power generation module 1A according to the second embodiment differs from the power generation module 1 according to the first embodiment in the arrangement of the submodules 30 in the X and Y directions. The power generation module 1A also differs from the power generation module 1 in that it includes electrode lead wires 73 and connection lead wires 74. In the following description of the second embodiment, the same reference numerals will be used to designate components similar to those in the power generation module 1, and descriptions thereof may be omitted.

As shown in Fig. 5, the power generation module 1A includes six submodules 30.

The six submodules 30 are aligned in both the X and Y directions in plan view. In this embodiment, the six submodules 30 form three rows R1 to R3 along the X direction and two columns C1, C2 along the Y direction. That is, the six submodules 30 are arranged in a matrix of three rows and two columns.

In the following description, the submodules 30 belonging to row R1 are denoted by reference numeral 301, the submodules 30 belonging to row R2 are denoted by reference numeral 302, and the submodules 30 belonging to row R3 are denoted by reference numeral 303.

Of the submodules 30 belonging to each of the columns C1, C2, submodules 301 are submodules located at one end in the Y direction. Submodules 303 are submodules located at the other end in the Y direction of the submodules 30 belonging to each of the columns C1, C2. Submodules 302 are submodules located between the submodule 301 and the submodule 303 in the Y direction.

The submodules 30 are each oriented such that, in plan view, the first end 31 is on the +Y side and the second end 32 is on the -Y side. Hence, the second end 32 of the submodules 301 is adjacent to the first end 31 of the submodules 302 in the Y direction. Furthermore, the second end 32 of the submodules 302 is adjacent to the first end 31 of the submodules 303 in the Y direction.

In each of the columns C1, C2, the three submodules 301 to 303 are electrically connected in series.

As shown in Figs. 5 and 6, the electrode lead wires 73 are connected to the second end 32 of the submodules 301, the first end 31 and second end 32 of the submodule 302, and the first end 31 of the submodules 303. As shown in Fig. 5, each electrode lead wire 73 extends over the entire length in the X direction of the first end 31 or the second end 32. The electrode lead wire 73 may have a structure in which the copper wire 701 is coated with the solder layer 702, similar to the first lead wire 71 and the second lead wire 72, for example.

In two submodules 30 adjacent to each other in the Y direction, the electrode lead wire 73 disposed at the second end 32 of one submodule 30 and the electrode lead wire 73 disposed at the first end 31 of the other submodule 30 are connected by the connection lead wire 74. In this way, the two submodules 30 adjacent to each other in the Y direction are connected to each other.

The number of the connection lead wires 74 disposed between the two submodules 30 is not particularly limited, but in this embodiment, there are two. The electrode lead wires 73 and the connection lead wires 74 may be connected by, for example, soldering.

As shown in Figs. 5 and 6, the first ends 31 of the submodules 301 belonging to the row R1 are connected to each other by the first lead wire 71. The second ends 32 of the submodules 303 belonging to the row R3 are connected to each other by the second lead wire 72.

The submodules 30 belonging to column C1 and the submodules 30 belonging to column C2 are electrically connected in parallel by the connection via the first lead wire 71 and the second lead wire 72.

According to the power generation module 1A described above, the plural submodules 30 are aligned in each of the X and Y directions that intersect with each other in plan view. This allows any number of submodules 30 to be aligned in the two intersection directions, which increases the degree of freedom in the shape and size of the power generation module 1A compared to the configuration in which the submodules 30 are aligned in only one row.

### (Third Embodiment)

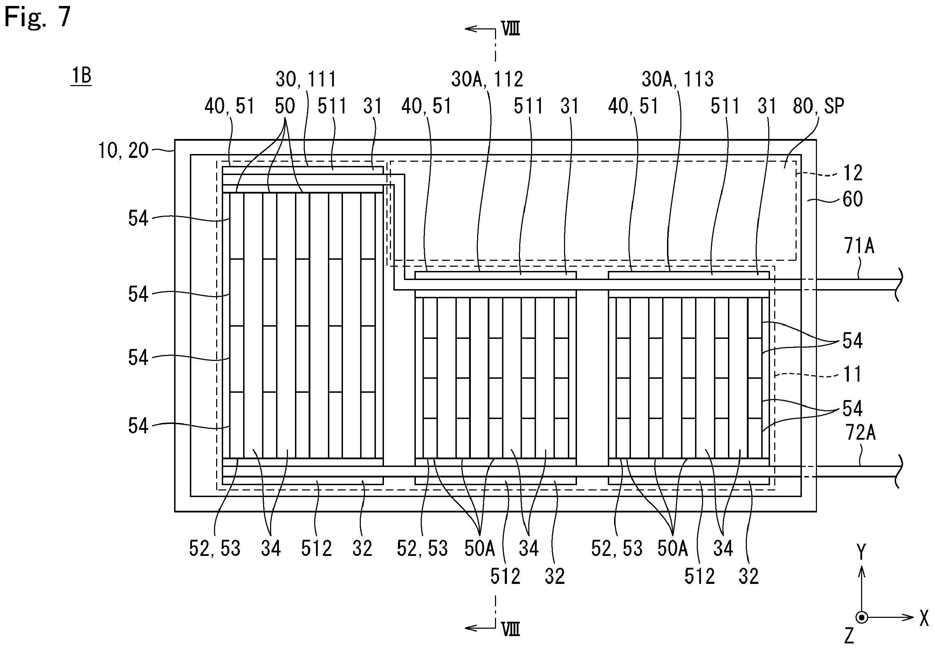

A power generation module 1B according to a third embodiment of the present disclosure will be described with reference to Fig. 7. Fig. 7 is a plan view of the power generation module according to the third embodiment of the present disclosure.

The power generation module 1B according to the third embodiment differs from the power generation module 1 according to the first embodiment in that it includes a plurality of submodules having different shapes in plan view.

As shown in Fig. 7, the power generation module 1B has one first submodule 30 and two second submodules 30A arranged along the X direction. Of the three submodules 30, 30A, the first submodule 30 is located furthest on the -X side. In this embodiment, the three submodules 30, 30A are arranged so that the second extension sections 512 are at the same position relative to each other in the Y direction.

The main surface of the first substrate 10 facing the second substrate 20 has, in plan view, an arrangement region 11 in which the three submodules 30, 30A are arranged, and a non-arrangement region 12 in which no submodules are arranged. In other words, the three submodules 30, 30A are arranged in the arrangement region 11. For example, the arrangement region 11 includes regions between the three submodules 30, 30A.

The non-arrangement region 12 is a region where the submodules 30, 30A are not arranged intentionally due to various reasons, such as the design of the power generation module 1B. For example, the non-arrangement region 12 does not include a narrow region where the submodules 30, 30A are simply not placed. For example, the non-arrangement region 12 has a rectangular shape in plan view. As shown in Fig. 7, in plan view, the non-arrangement region 12 has an area that is greater than the area of the smallest submodule among the submodules arranged in the power generation module 1B.

In this embodiment, because the first substrate 10 and the second substrate 20 are transparent, the power generation module 1B is in a transmissive state in the non-arrangement region 12. Therefore, an object placed in one space (e.g., indoors) separated by the power generation module 1B can be displayed in the other space (e.g., outdoors) through the non-arrangement region 12, as if the object were visible through a glass window. For example, if the power generation module 1B is installed on the wall of a store, a sign placed inside the store can be displayed outside through the non-arrangement region 12. Furthermore, letters, figures, patterns, etc. can also be displayed directly in the non-arrangement region 12.

The three submodules 30, 30A may be arranged so that the positions of the second extension sections 512 in the Y direction are offset from each other as long as they are positioned side by side along the X direction as a whole.

The first submodule 30 and the second submodule 30A have the same or substantially the same dimensions in the X direction. Here, the X direction is an example of the "first direction" in the present disclosure. The second submodule 30A has dimensions in the Y direction that are different from those of the first submodule 30. In this embodiment, the dimension in the Y direction of the second submodule 30A is smaller than the dimension in the Y direction of the first submodule 30. Here, the Y direction is an example of the "second direction" in the present disclosure. For example, the dimension in the Y direction of the first submodule 30 is equal to or less than twice the dimension in the Y direction of the second submodule 30A. This is because if the dimensions in the Y direction differ significantly between the first submodule 30 and the second submodule 30A, it would be difficult to design the solar cell element 54.

The power generation module 1B includes a first lead wire 71A and a second lead wire 72A that connect the three submodules 30, 30A. The first lead wire 71A connects the first extensions 511 disposed on the three submodules 30, 30A. The positions of the first extensions 511 in the Y direction are different between the first submodule 30 and the second submodule 30A. Therefore, the first lead wire 71A bends in the Y direction at a position between the first submodule 30 and the second submodule 30A in the X direction. The second lead wire 72A connects the second extensions 512 disposed on the three submodules 30, 30A. In this embodiment, the positions of the second extensions 512 in the Y direction are the same, so that the second lead wire 72A has a rectilinear shape extending along the X direction.

As shown in Fig. 7, the first submodule 30 includes a plurality of first solar cells 50 extending along the Y direction between the first extension 511 and the second extension 512. Similarly, the second submodule 30A includes a plurality of second solar cells 50A extending along the Y direction between the first extension 511 and the second extension 512. In this embodiment, each submodule 30, 30A includes five solar cells 50, 50A. Each solar cell 50, 50A has a rectilinear shape extending along the Y direction.

In each submodule 30, 30A, the five solar cells 50, 50A are spaced apart in the X direction. Since no solar cell elements 54 are arranged in the spaced apart regions, the solar cells 50, 50A do not generate power and allow light to pass through. In this embodiment, the five solar cells 50, 50A are arranged at equal intervals and parallel or approximately parallel to each other. As a result, each submodule 30, 30A has a border-like appearance in the X direction, with regions that are difficult to transmit light and regions that are easy to transmit light alternating, as shown in Fig. 7. Each of the solar cells 50, 50A is connected at both ends to the first lead wire 71A and the second lead wire 72A, respectively. As a result, the five solar cells 50, 50A are connected in parallel by the first lead wire 71A and the second lead wire 72A.

Each solar cell 50, 50A has one solar cell element 54 or plural solar cell elements 54 connected in series. The first solar cell 50 and the second solar cell 50A have the same number of solar cell elements 54. In this embodiment, the first solar cell 50 has four solar cell elements 54 connected in series. In Fig. 7, the separations of the semiconductor layer 52 and the second electrode layer 53 between adjacent solar cell elements 54 (see Fig. 3) are indicated by lines.

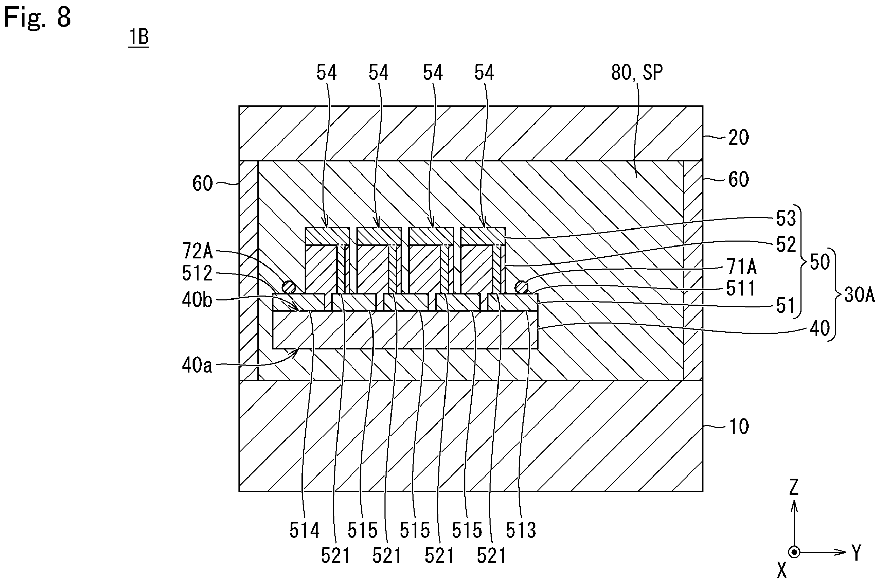

Fig. 8 is a cross-sectional view taken along line VIII-VIII in Fig. 7. As shown in FIGS. 7 and 8, the second solar cell 50A has four solar cell elements 54 connected in series. In Fig. 7, the separations of the semiconductor layer 52 and the second electrode layer 53 between adjacent solar cell elements 54 (see Fig. 8) are indicated by lines. The solar cell elements 54 constituting the second solar cell 50A have smaller dimensions in the Y direction than the solar cell elements 54 constituting the first solar cell 50. Meanwhile, the thickness and composition in the Z direction of the semiconductor layer 52 constituting the solar cell elements 54 are the same between the first solar cell 50 and the second solar cell 50A. Therefore, the electromotive force in each solar cell element 54 when the semiconductor layer 52 receives light is the same regardless of the solar cell 50, 50A in which the solar cell element 54 is located.

As shown in Fig. 7, each submodule 30, 30A has a region 34 between solar cell elements 50, 50A adjacent to each other in the Y direction. The semiconductor layer 52 disposed in each solar cell 50, 50A is separated from the semiconductor layer 52 disposed in the adjacent solar cell 50, 50A by the region 34. In this embodiment, the semiconductor layer 52 and the second electrode layer 53 are not disposed in the region 34. On the other hand, the first electrode layer 51 may be disposed in the region 34. In this case, the first electrode layer 51 located in the region 34 may connect the first electrode layers 51 mutually between solar cell elements 54 adjacent to each other in the X direction.

According to the above power generation module 1, 1A, 1B, by changing the arrangement of the plural submodules 30, 30A, it is possible to more easily dispose the non-arrangement region 12 in the power generation module 1, 1A, 1B where no solar cells 50, 50A are arranged. For example, in the non-arrangement region 12, an object arranged in one space (e.g., indoors) separated by the power generation module 1, 1A, 1B can be displayed in the other space (e.g., outdoors) through the non-arrangement region 12. Furthermore, components unrelated to power generation can be incorporated into the non-arrangement region 12. This allows the power generation module 1, 1A, 1B to be easily used as a building material and have a high degree of flexibility. Furthermore, according to the above power generation module 1B, plural submodules 30, 30A with different dimensions in at least one of the X and Y directions are disposed, thereby allowing the power generation module 1B to be easily used as a building material and have a high degree of flexibility.

Furthermore, in the power generation module 1B described above, the first solar cell 50 and the second solar cell 50A have the same number of solar cell elements 54. When the power generation module 1B includes plural submodules 30, 30A with different dimensions in the Y direction, it is possible to reduce the number of solar cell elements 54 disposed in each second solar cell 50A. In this case, the number of solar cell elements 54 connected in series in the second solar cell 50A is fewer than the number of solar cell elements 54 connected in series in the first solar cell 50. The magnitude of the voltage generated in the solar cell 50, 50A depends on the number of solar cell elements 54 connected in series in the solar cell 50, 50A. Therefore, the output voltage of the second solar cell 50A is lower than the output voltage of the first solar cell 50. As a result, the output voltage of the power generation module 1B becomes lower because it conforms to the lower voltage of the second solar cell 50A.

On the other hand, in the power generation module 1B described above, the first solar cell 50 and the second solar cell 50A have the same number of solar cell elements 54, despite having different dimensions in the Y direction. This makes it possible to suppress a decrease in the output voltage of the power generation module 1B due to a decrease in the number of solar cell elements 54 constituting each solar cell 50, 50A. It becomes thus possible to suppress a decrease in the power generation efficiency of the power generation module 1B.

### (Variant)

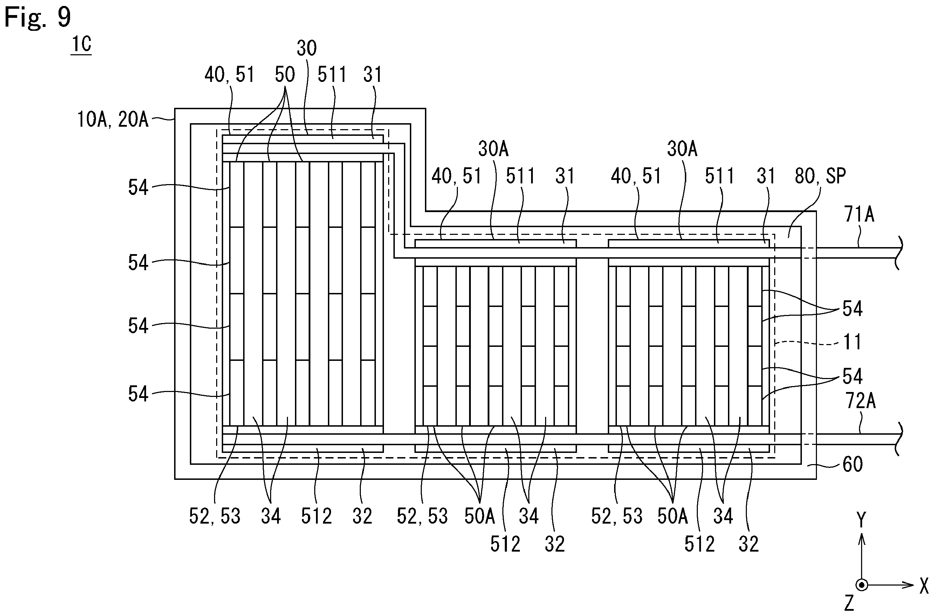

Fig. 9 is a plan view of a power generation module according to a variant of the third embodiment of the present disclosure. A power generation module 1C shown in Fig. 9 differs from the power generation module 1B shown in the third embodiment in the planar shapes of the first substrate and the second substrate.

In the example shown in Fig. 9, the power generation module 1C includes a first substrate 10A and a second substrate 20A. The first substrate 10A and the second substrate 20A are L-shaped in plan view. More specifically, the first substrate 10A and the second substrate 20A have a shape similar to that of the first substrate 10 and the second substrate 20 (see Fig. 7) in the power generation module 1B, with most of the non-arrangement region 12 removed. Therefore, the main surface of the first substrate 10 is the arrangement region 11, excluding the portion where the sealing member 60 is arranged. That is, the three submodules 30, 30A are arranged so as to be densely packed on the main surface. Meanwhile, the non-arrangement region 12 is not disposed on the main surface. Similar to the power generation module 1B according to the third embodiment, the solar cell cells 50, 50A disposed in the submodules 30, 30A each have four solar cell elements 54 connected in series.

In plan view, the first lead wire 71A and the second lead wire 72A extend along the edges of the first substrate 10 and the second substrate 20. By positioning each lead wire 71A, 72A near the first substrate 10 and the second substrate 20, the region between the two lead wires 71A, 72A is increased, thereby increasing the region in which the submodules 30, 30A can be installed.

### (Fourth Embodiment)

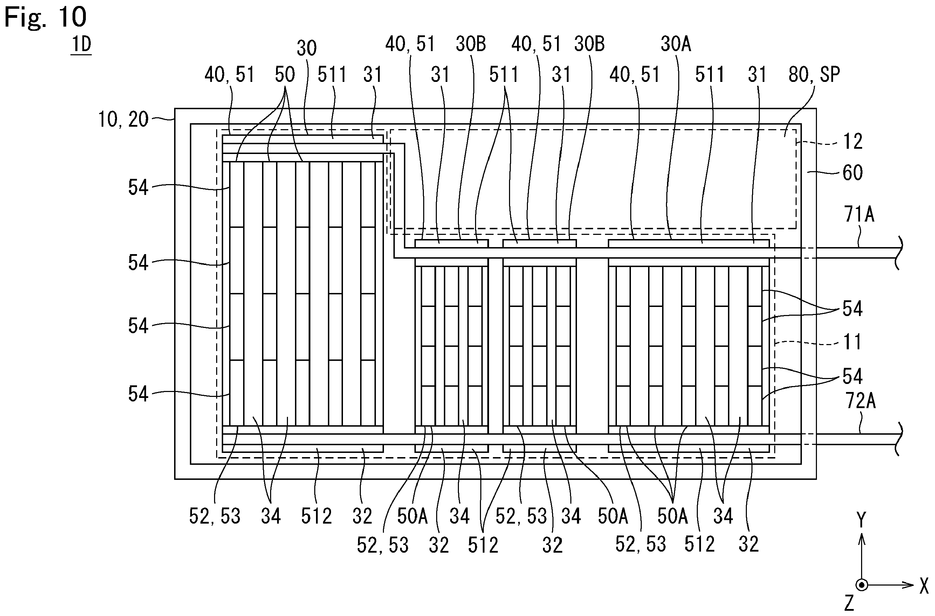

A power generation module 1D according to a fourth embodiment of the present disclosure will be described with reference to Fig. 10. Fig. 10 is a plan view of the power generation module according to the fourth embodiment of the present disclosure.

The power generation module 1D according to the fourth embodiment differs from the power generation module 1B according to the third embodiment in that it includes two third submodules 30B instead of one second submodule 30A. That is, the power generation module 1D includes one first submodule 30, one second submodule 30A, and two third submodules 30B.

The four submodules 30, 30A, 30B are arranged side by side along the X direction. The third submodule 30B is located between the first submodule 30 and the second submodule 30A in the X direction. The third submodule 30B has the same or substantially the same dimensions as the second submodule 30A in the Y direction. On the other hand, the third submodule 30B has dimensions in the X direction that are smaller than the first submodule 30 and the second submodule 30A. In other words, the third submodule 30B has dimensions in both the X direction and the Y direction that are different from the first submodule 30.

The first submodule 30 and the second submodule 30A each include five solar cells 50, 50A, similar to the power generation module 1B according to the third embodiment. The third submodule 30B includes the second solar cell 50A.

The number of solar cells in the third submodule 30B may be the same as or different from the number of solar cells in each of the submodules 30, 30A. In this embodiment, since the third submodule 30B is smaller than each of the submodules 30, 30A in the Y direction, the number of solar cells 50A in the third submodule 30B is three, which is fewer than the number of solar cells in each of the submodules 30, 30A. In the third submodule 30B, each solar cell 50A is connected at both ends to the first lead wire 71A and the second lead wire 72A, respectively.

In this embodiment, each of the solar cell units 50, 50A disposed in the submodules 30, 30A, 30B has four solar cell elements 54 connected in series. That is, the number of solar cell elements 54 in each of the solar cell units 50 and 50A is the same among the submodules 30, 30A, 30B.

### (Fifth Embodiment)

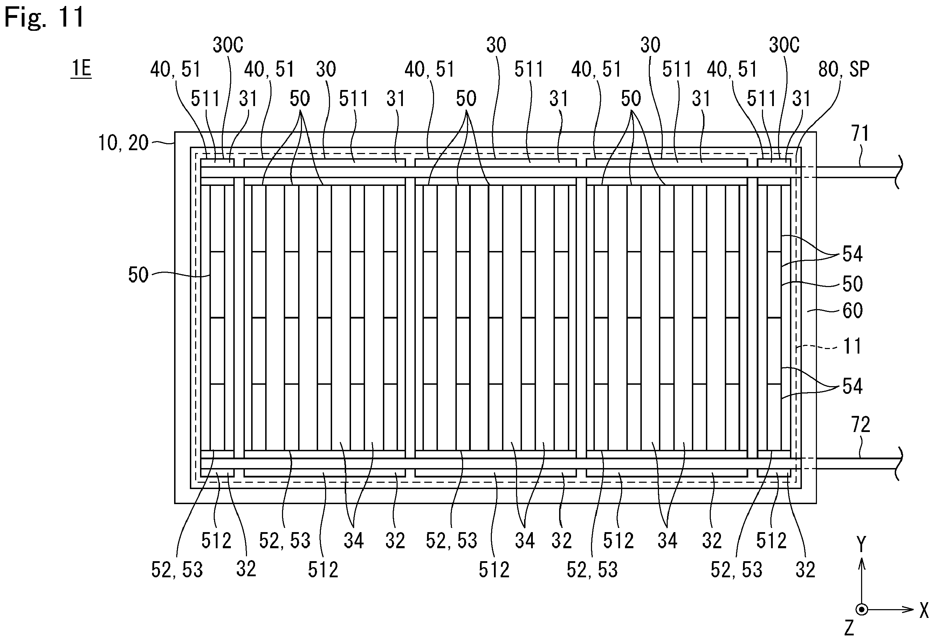

A power generation module 1E according to a fifth embodiment of the present disclosure will be described with reference to Fig. 11. Fig. 11 is a plan view of the power generation module according to the fifth embodiment of the present disclosure.

The power generation module 1E according to the fifth embodiment differs from the power generation module 1 according to the first embodiment in that it further includes two fourth submodules 30C. That is, the power generation module 1E includes three first submodules 30 and two fourth submodules 30C.

The five submodules 30, 30C are arranged side by side in the X direction. The three first submodules 30 are positioned between the two fourth submodules 30C in the X direction. The five submodules 30, 30C are arranged so as to be spread out on the first substrate 10 in the internal space SP. Therefore, the main surface of the first substrate 10 forms the arrangement region 11 except for the portion where the sealing member 60 is arranged. On the other hand, no non-arrangement region 12 is disposed on this main surface.

The fourth submodule 30C has the same or substantially the same dimensions as the first submodule 30 in the Y direction. On the other hand, the fourth submodule 30C has dimensions in the X direction smaller than the first submodule 30 and the second submodule 30A. The first submodule 30 and the fourth submodule 30C include the linear solar cell 50 described above. The first submodule 30 includes five solar cell cells 50 each, similar to the first submodule 30 disposed in the power generation module 1B (Fig. 7).

The number of solar cells in the fourth submodule 30C may be the same as or different from the number of solar cells in the first submodule 30. In this embodiment, since the fourth submodule 30C is smaller than the first submodule 30 in the Y direction, the number of solar cells 50 in the fourth submodule 30C is three, which is fewer than the number of solar cells in the first submodule 30. In the fourth submodule 30C, each solar cell 50 is connected at both ends to the first lead wire 71 and the second lead wire 72, respectively.

In this embodiment, each solar cell 50 disposed in the submodules 30 and 30C has four solar cell elements 54 connected in series. That is, the number of solar cell elements 54 in each solar cell 50 is the same between the submodules 30 and 30C.

### (Method for Manufacturing Power Generation Module)

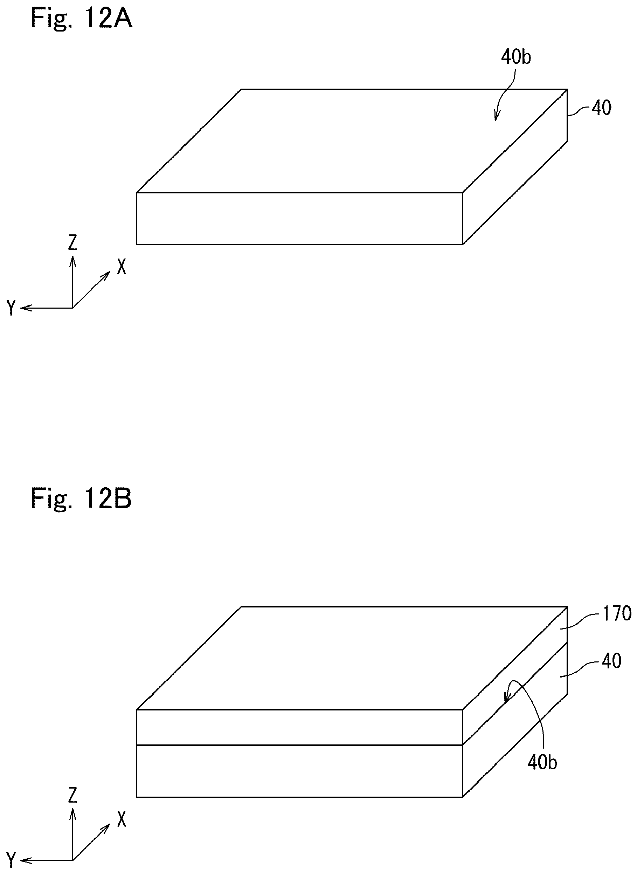

A method for manufacturing the power generation module 1B according to the third embodiment of the present disclosure will be described with reference to Figs. 12A to 14.

The manufacturing method of the submodules 30, 30A includes a film formation process of forming a stacked film including a solar cell film (semiconductor layer 52) on the upper surface 40b of the base member 40, a film processing process of processing the stacked film to form the solar cells 50, 50A, and a wiring formation process of arranging wiring (lead wires 71A, 72A) that electrically connects to the solar cells 50, 50A.

### • Film Formation Process

Figs. 12A and 12B are schematic process perspective views showing the film formation process.

First, as shown in Fig. 12A, a base member 40 having a light-transmitting property is prepared. In this example, a glass substrate is prepared as the base member 40. Instead, a substrate whose surface is covered with a transparent conductive film, such as an FTO substrate, may be used.

Next, as shown in Fig. 12B, a stacked film 170 including a lower transparent conductive film, a solar cell film, and an upper transparent conductive film in this order from the upper surface 40b side of the base member 40 is formed on the upper surface 40b of the base member 40.

Each film in the stacked film 170 is formed by a known method and patterned as necessary. For example, patterning of the lower transparent conductive film, formation of a contact portion connecting the upper transparent conductive film and the lower transparent conductive film, etc. may be performed as appropriate. When a substrate whose surface is covered with a transparent conductive film, such as an FTO substrate, is used, the transparent conductive film on the substrate surface may be used as the lower transparent conductive film in the stacked film 170.

The solar cell film includes, for example, a perovskite compound. The solar cell film is applied onto the lower transparent conductive film formed on the upper surface 40b of the base member 40 by a method such as spin coating or inkjet printing. The solar cell film is, for example, a stacked film including an n-type semiconductor film, an i-type semiconductor film (perovskite layer), and a p-type semiconductor film. First, the n-type semiconductor film is applied using an inkjet printing method and dried, and then the i-type semiconductor film that will become the upper layer is applied using an inkjet printing method and dried. Similarly, the p-type semiconductor film is applied using an inkjet printing method and dried to form a stacked film. The stacked film that will become the solar cell film may be formed by repeating the application and drying in this manner.

### • Film Processing Process

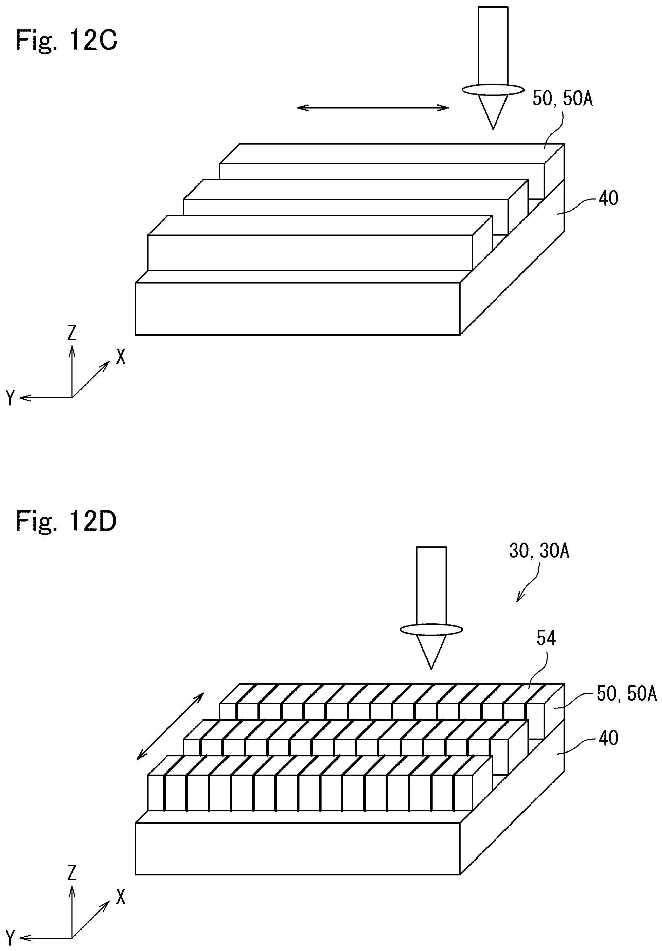

In the film processing process, first, as shown in Fig. 12C, a laser beam is scanned in the Y direction to perform a first laser processing process (cell formation step) on the stacked film 170 formed by the above method, and a portion of the stacked film 170 is removed from the upper surface 40b of the base member 40. Here, a scribing process such as laser scribing is performed. The portion of the stacked film 170 that is not removed and remains on the upper surface 40b of the base member 40 serves as the solar cell 50, 50A.

Subsequently, as shown in Fig. 12D, a second laser processing process (element separation step) is performed by scanning the laser light in the X direction. As a result, a plurality of separation grooves 160 extending in the X direction are formed in each solar cell 50, 50A, separating the solar cell into a plurality of solar cell elements 54. In this way, a stacked structure L exemplified in Fig. 3 is obtained.

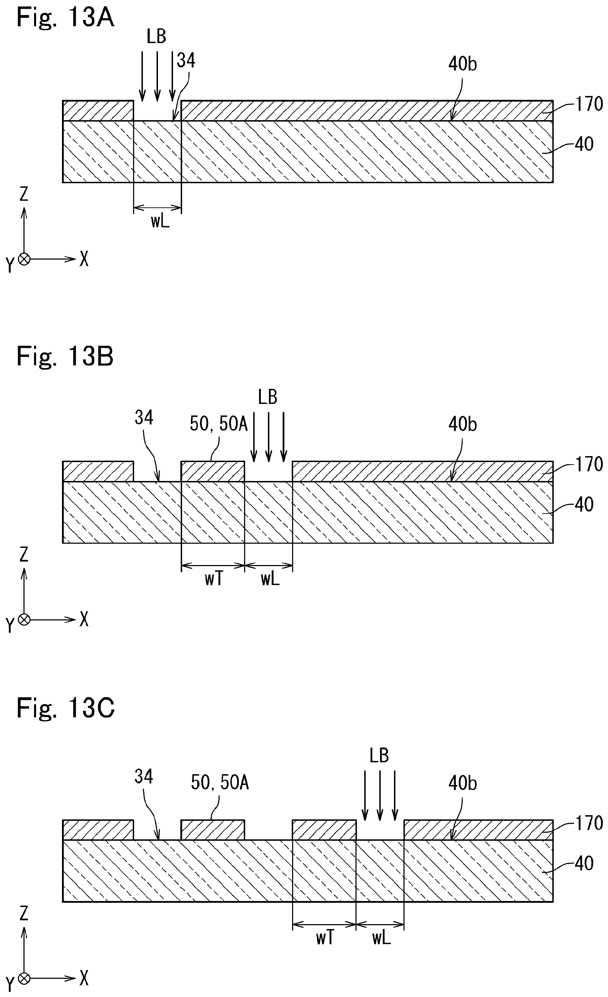

The first laser processing process (Fig. 12C) will be described in more detail below with reference to Figs. 13A to 13C. Here, an example will be described in which the lower transparent conductive film, solar cell film, and upper transparent conductive film that make up the stacked film 170 are all removed simultaneously by laser processing. It is sufficient that at least a portion of the solar cell film is removed from the base member 40 by laser processing. The other transparent conductive films may be processed by a different method than the solar cell film and may have a different pattern.

Figs. 13A to 13C are each a schematic cross-sectional view showing the film processing process.

As shown in Fig. 13A, the laser beam LB is scanned in the Y direction, and the stacked film 170 is irradiated with the laser beam LB over a predetermined irradiation range (referred to as "irradiation width") wL. This removes the irradiated portion of the stacked film 170. The removed portion becomes a linear region 34 extending in the Y direction. If the irradiation width wL is wide, plural scans may be performed to irradiate the predetermined range wL. In this example, the stacked film 170 is removed throughout the thickness direction, exposing a portion of the upper surface 40b of the base member 40.

Next, as shown in Fig. 13B, the laser head is moved to shift the irradiation position of the laser beam LB in the X direction by a predetermined distance (referred to as "non-irradiation width") wT. In this state, the laser beam LB is scanned in the Y direction to irradiate the stacked film 170 with the laser at an irradiation width wL, thereby removing a portion of the stacked film 170. Between two removed portions adjacent to each other in the X direction, a linear stacked structure having the same width as the non-irradiation width wT, i.e., solar cell 50, 50A, is formed. As shown in Fig. 13C, the laser irradiation of the stacked film 170 is continued while shifting the irradiation position in the X direction. In this manner, solar cell 50, 50A arranged at equal intervals in the X direction can be formed on the upper surface 40b of the base member 40.

The irradiation width wL and non-irradiation width wT of the laser light LB can be set appropriately depending on the desired width and power generation amount of the solar cell 50, 50A. For example, the irradiation width wL1 of the laser light LB when manufacturing the first submodule 30 may be larger than the irradiation width wL2 when manufacturing the second submodule 30A. Alternatively, the non-irradiation width wT1 when manufacturing the first submodule 30 may be smaller than the non-irradiation width wT2 when manufacturing the second submodule 30A.

### • Wiring Formation Process

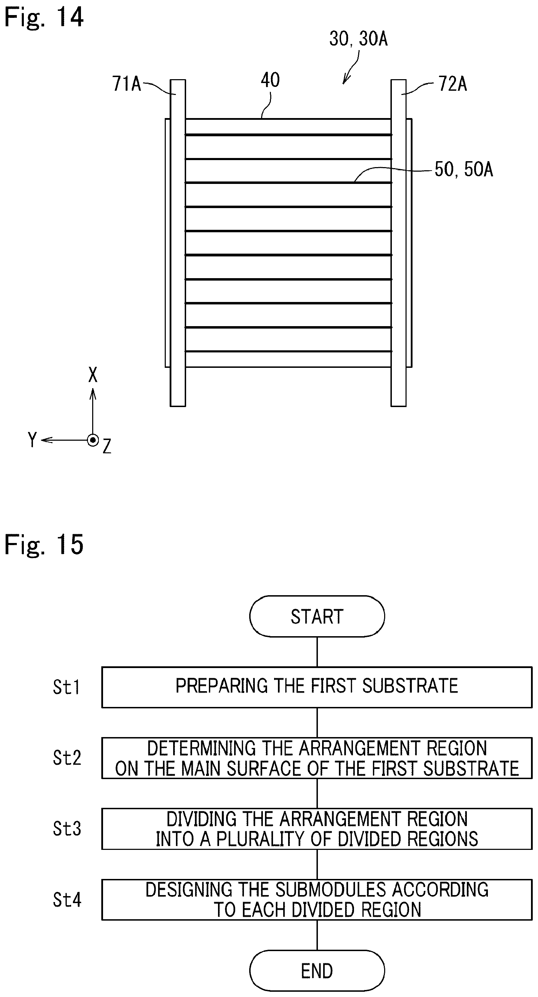

Fig. 14 is a schematic top view showing the wiring formation step. As shown in Fig. 14, wiring (e.g., lead wires) 71A, 72A are formed on the base member 40 on which the solar cell 50, 50A has been formed by the above method. In this manner, the submodule 30, 30A is manufactured.

The lead wires 71A, 72A are respectively arranged on one end side and the other end side of the base member 40 in the Y direction. In plan view seen along the Z direction, the lead wires 71A, 72A are longer than the length of the base member 40 in the X direction, and both ends of the lead wires 71A, 72A may extend outside the base member 40. The lead wire 71A is connected to the upper or lower transparent conductive layer at one end of each solar cell 50, 50A at one end side of the base member 40. Similarly, the lead wire 72A is connected to the upper or lower transparent conductive layer at the other end of each solar cell 50, 50A at the other end side of the base member 40. Each of the lead wires 71A, 72A may be connected to the lower transparent conductive layer by, for example, soldering.

A method for manufacturing the power generation module 1B using the submodules 30 and 30A manufactured by the above method will be described.

The method for manufacturing the power generation module includes, for example, a submodule arrangement process in which plural submodules are arranged on a first substrate and electrically connected to each other, and a sealing process in which the first substrate and the second substrate are bonded together with the plural submodules sandwiched between them.

### • Submodule Arrangement Process

First, the first substrate 10 (e.g., a glass substrate) is prepared, and the submodules 30 and 30A are arranged on the first substrate 10 via a filler (filler 80 shown in Fig. 2, etc.). At this time, the submodules 30 and 30A are arranged so that the first submodule 30 and the second submodule 30A have different dimensions in the Y direction. For example, a filler sheet containing polyolefin is used as the filler.

Next, the first extensions 511 of the submodules 30, 30A are connected to each other by first lead wires 71A. Similarly, the second extensions 512 of the submodules 30, 30A are connected to each other by second lead wires 72A. At this time, the second lead wires 72A are formed so as to bend in the Y direction outside the submodules 30, 30A. The second lead wires 72A may be bent simultaneously with joining to the second extensions 512, or may be bent into a desired shape in advance and then joined to the second extensions 512.

### • Sealing Process

After the lead wires 71A, 72A are arranged as described above, the second substrate 20 is arranged above the submodules 30, 30A via the filler 80. For example, a filler sheet containing polyolefin is used as the filler 80. The filler 80 may have a size larger than the region in which the submodules 30 and 30A are arranged when viewed in plan view from the Z direction.

Afterward, lamination is performed. In the lamination, the filler 80 melts under reduced pressure and wraps around to cover the side surfaces of the submodules 30 and 30A, bonding the first substrate 10 and the second substrate 20 together. This reduces the likelihood of air remaining near the side surfaces of the submodules 30, 30A, thereby suppressing the influence of air on the solar cell layer. The entire side surfaces of the submodules 30, 30A may be covered with the filler 80. Next, a sealing member (e.g., butyl rubber) 60 is placed around the peripheries of the first substrate 10 and the second substrate 20 between the first substrate 10 and the second substrate 20, thereby sealing the internal space SP. In this manner, the power generation module 1B is manufactured.

In the above, the sealing member 60 is disposed for sealing after the lamination, but the lamination may be performed after the sealing member 60 is disposed for sealing.

### (Method for Designing Power Generation Module)

Referring to Figs. 7 and 15, a method for designing the power generation module 1B according to the present disclosure will be described. The method for designing the power generation module 1B includes four steps St1 to St4 shown in Fig. 15.

In the first step St1, the above first substrate 10 is prepared. The shape of the first substrate 10 in plan view is not particularly limited, and may be, for example, a polygon, an L-shape, a T-shape, a circle, or an ellipse.

In the second step St2, the arrangement region 11 for the submodules 30 and 30A is determined on the main surface of the first substrate 10. For example, if the power generation module 1B is used as a window, the region of the main surface excluding the region where the sealing member 60 is installed and the non-arrangement region 12 is determined as the arrangement region 11. Here, the non-arrangement region 12 may be a region where transparency is desired when used as a window. Note that if there is no need to dispose the non-arrangement region 12 (e.g., see Fig. 9), the region of the main surface excluding the region where the sealing member 60 is installed may be determined as the arrangement region 11. The shape of the arrangement region 11 is not particularly limited and may be, for example, a polygon, an L-shape, a T-shape, a circle, or an ellipse. However, in many cases, the shape of each submodule is rectangular in plan view. In this case, it is effective to form the arrangement region 11 in an L-shape or a T-shape, which can be easily implemented when the submodules are arranged so that the sides of the rectangle are aligned.

In the third step St3, the arrangement region 11 determined in the second step St2 is divided into a plurality of divided regions. Each divided region is a region in which one submodule is placed. In the example of the power generation module 1B shown in Fig. 7, the arrangement region 11 is divided into three divided regions 111 to 113 corresponding to the three submodules 30 and 30A, respectively. In this embodiment, the divided region 111 corresponds to the first submodule 30, and the two divided regions 112 and 113 correspond to the two second submodules 30A, respectively.

The shape of each of the divided regions 111 to 113 may be the shape of the submodules 30 and 30A designed in the fourth step St4 described below. In this embodiment, each of the divided regions 111 to 113 is rectangular. The dimension of the divided region 111 in the Y direction is larger than the dimensions of the divided regions 112 and 113 in the Y direction.

In the fourth step St4, the submodules 30 and 30A are designed according to the divided regions 111 to 113 determined in the third step St3. Because the divided region 111 is larger in the Y direction than the divided regions 112 and 113, the first submodule 30 is designed to be larger in the Y direction than the second submodule 30A.

The solar cell 50, 50A disposed in each submodule 30, 30A is designed so that the number of solar cell elements 54 connected in series is the same. This ensures that the power generation voltages of the solar cell 50, 50A are uniform, thereby suppressing a decrease in the power generation voltage of the entire power generation module 1B. Furthermore, the dimension of each solar cell element 54 in the Y direction is adjusted so that solar cell 50, 50A having the same number of solar cell elements 54 are formed even in submodules 30, 30A with different dimensions in the Y direction. Specifically, the solar cell element 54 constituting the first solar cell 50 is designed to be larger in the Y direction than the solar cell element 54 constituting the second solar cell 50A.

The power generation module 1B designed by the above design method can be manufactured by the above manufacturing method.

The present disclosure is not limited to the above embodiments, but can be embodied in various other forms.

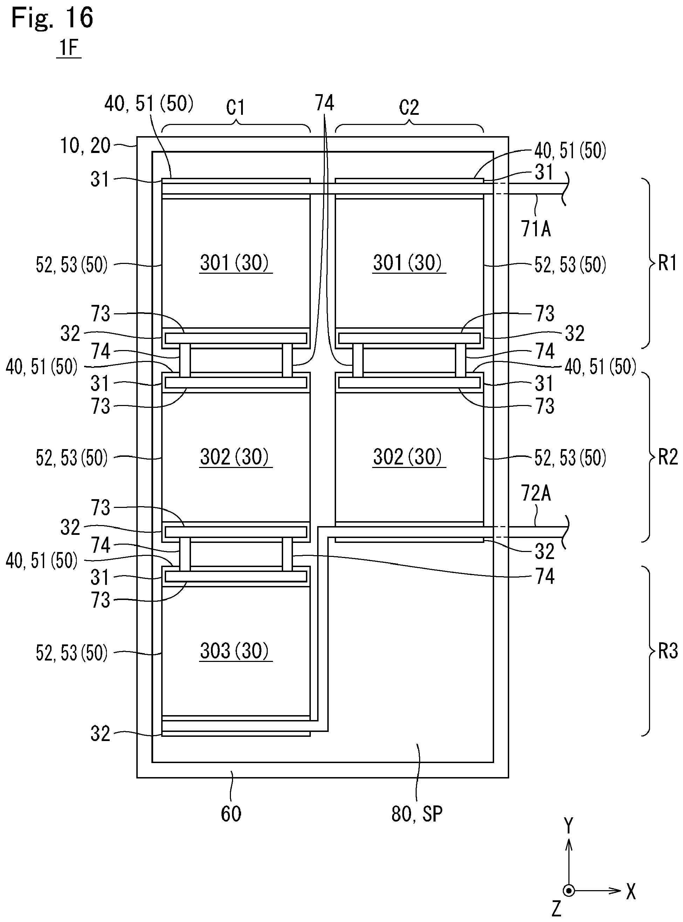

In the second embodiment, the number of submodules 30 belonging to each column C1, C2 may be different. Fig. 16 is a plan view of a power generation module 1F according to a variant of the second embodiment of the present disclosure. Note that in Fig. 16, the separations of the semiconductor layer 52 and the second electrode layer 53 are not depicted.

The power generation module 1F shown in Fig. 16 lacks the submodule 303 in the column C2 that was disposed in the power generation module 1A. In this case, the second lead wire 72A is connected to the second end 32 of the submodule 30 that is farthest in the Y direction from the first lead wire 71A in each of the columns C1, C2. In other words, the second lead wire 72 is connected to the second end 32 of the submodule 303 in the column C1 and the second end 32 of the submodule 302 in the column C2.

The number of the solar cell elements 54 disposed in each of the submodules 301, 302 belonging to the column C2 may be different from the number of the solar cell elements 54 disposed in each of the submodules 301, 302 belonging to the column C1.

The internal space SP may be hollow and not filled with the filler 80. In this case, the internal space SP may be filled with a gas such as air, nitrogen, or argon.

The base member 40 may be disposed in contact with the first substrate 10 in the internal space SP.

The base member 40 may be any member that serves as a base for stacking the solar cell 50 that is stacked on the base member 40. For example, if the lead wires 71, 72 are connected to the first electrode layer 51 by a method other than soldering, the base member 40 need not be heat resistant.

Furthermore, although the submodule 30 is described above as being oriented such that the solar cells 50 are located above the base member 40, the present disclosure is not limited thereto. For example, the submodule 30 may be oriented upside down relative to the orientation in the above embodiment. That is, the first electrode layer 51 may be disposed directly on the lower surface 40a of the base member 40, and the semiconductor layer 52 and the second electrode layer 53 may be stacked below the base member 40.

In this case, for example, if the base member 40 and the first electrode layer 51 are configured to be translucent, light that enters the internal space SP through the second substrate 20 can reach the semiconductor layer 52 through the base member 40 and the first electrode layer 51. In this case, the second electrode layer 53 located below the semiconductor layer 52 need not have a light-transmitting property.

In the first embodiment, each lead wire 71, 72 is connected to the first extension 511 or the second extension 512, but the present disclosure is not limited thereto. For example, each lead wire 71, 72 may be connected to a portion of the first electrode layer 51 excluding the first extension 511 or the second extension 512. Each lead wire 71, 72 may be connected to the second electrode layer 53. Each lead wire 71, 72 may be connected to a different electrode layer 51, 53 for each solar cell 50.

In the first embodiment, the first substrate 10, the second substrate 20, the base member 40, the first electrode layer 51, the second electrode layer 53, and the filler 80 are transparent, but the present disclosure is not limited thereto. The second substrate 20, the second electrode layer 53, and the filler 80 may be configured as opaque or colored members as long as they are translucent so as to allow light necessary for power generation to enter the semiconductor layer 52. The first electrode layer 51 may be an electrode made of, for example, a metal such as silver, aluminum, copper, or molybdenum, or an alloy thereof. Furthermore, if the power generation module is used as a building material other than a window, the first substrate 10, the second electrode layer 53, and the base member 40 need not be transparent.

In the second embodiment, the electrode lead wire 73 need not be disposed. In this case, the first electrode layers 51 of different solar cell units 50 may be connected to each other by the connection lead wire 74. By disposing the electrode lead wire 73, the electrical resistance at the connection portion of the two solar cell units 50 can be reduced.

In the second embodiment, six submodules 30 are arranged in a matrix of three rows and two columns, but the present disclosure is not limited thereto. The number of submodules 30 belonging to each row may be different as long as there are two or more submodules in at least one row. The number of submodules 30 belonging to each column may be different as long as there are two or more submodules in at least one column.

In the above embodiment, the first substrate 10 and the second substrate 20 are rectangular in plan view, but the present disclosure is not limited thereto. For example, the first substrate 10 and the second substrate 20 may be circular, elliptical, polygonal, L-shaped, T-shaped, etc.

The number of the solar cell elements 54 disposed in each solar cell 50, 50A is not limited to four, but may be one to three, or five or more.

Any of the various embodiments or variants described above can be combined appropriately to achieve the effects of each. In addition, combinations of embodiments, combinations of examples, or combinations of embodiments and examples are possible, and combinations of features from different embodiments or examples are also possible.

Although the present disclosure has been fully described in connection with the preferred embodiments with reference to the accompanying drawings, various changes and modifications will be apparent to those skilled in the art, and such changes and modifications are to be understood as being encompassed within the scope of the present disclosure as defined by the appended claims unless they depart therefrom.

### (Summary of Embodiments)

(1) A power generation module of the present disclosure includes: a first substrate having a light-transmitting property; a second substrate having a light-transmitting property, the second substrate facing the first substrate in a thickness direction of the first substrate; and a plurality of submodules positioned side by side in a direction intersecting the thickness direction between the first substrate and the second substrate. Each submodule has a base member and a solar cell disposed on the base member. The solar cell has a first electrode layer stacked on the base member, a semiconductor layer stacked on the first electrode layer, and a second electrode layer stacked on the semiconductor layer.
(2) In the power generation module of (1), it further includes a first lead wire and a second lead wire that electrically connect the solar cells to one another in parallel among the plurality of submodules. The plurality of submodules are aligned in a row in plan view seen along the thickness direction. Each submodule has a first end in a transverse direction intersecting both the thickness direction and the alignment direction of the plurality of submodules, and a second end located opposite to the first end. The first lead wire is connected to the first electrode layer or the second electrode layer at the first end of each submodule. The second lead wire is connected to the first electrode layer or the second electrode layer at the second end of each submodule.
(3) In the power generation module of (2), each of the first lead wire and the second lead wire connects the first electrode layers disposed in the plurality of submodules to one another.
(4) In the power generation module of (3), the first electrode layer has an extension that protrudes from the semiconductor layer in a transverse direction intersecting both the thickness direction and the alignment direction in the plan view. Each of the first lead wire and the second lead wire is connected to the extension.
(5) In the power generation module of (1), the plurality of submodules are aligned in two directions intersecting one other in plan view seen along the thickness direction.
(6) In the power generation module of any one of (1) to (5), it further includes a first lead wire and a second lead wire that are connected to the first electrode layer or the second electrode layer in each submodule, the first lead wire and the second lead wire electrically connecting the solar cells to one another in parallel among the plurality of submodules. Each of the first lead wire and the second lead wire includes a copper wire and a solder layer covering the copper wire. The solder layer constitutes the outermost layer of each of the first lead wire and the second lead wire.
(7) In the power generation module of any one (1) to (6), the base member is a glass plate.
(8) In the power generation module of any one of (1) to (7), the semiconductor layer includes a perovskite material.
(9) In the power generation module of any one of (1) to (8), each of the plurality of submodules has the base member and a plurality of solar cells disposed on a main surface of the base member. Each of the plurality of solar cells extends from one end to the other end of the base member in plan view seen along the thickness direction, the plurality of solar cells each having a structure, a plurality of solar cell elements being connected in series in the structure. The plurality of solar cells are arranged at intervals in an intersection direction intersecting with an extension direction of the plurality of solar cells in each of the plurality of submodules. Each of the plurality of submodules has a region between adjacent solar cells in the plan view. The semiconductor layer disposed in each of the plurality of solar cells is apart from the semiconductor layer disposed in a solar cell adjacent thereto via the region.
(10) A method for manufacturing a power generation module of the present disclosure includes: preparing a first substrate and a second substrate, each of the first substrate and the second substrate having a light-transmitting property; preparing a plurality of submodules each having a base member and a solar cell disposed on the base member; arranging the plurality of submodules side by side on the first substrate in a direction intersecting a thickness direction of the first substrate; and disposing the second substrate facing the first substrate in the thickness direction, the plurality of submodules being positioned between the second substrate and the first substrate. The solar cell has a first electrode layer stacked on the base member, a semiconductor layer stacked on the first electrode layer, and a second electrode layer stacked on the semiconductor layer.
(11) A power generation module of the present disclosure includes: a first substrate having a light-transmitting property; a second substrate having a light-transmitting property, the second substrate facing the first substrate in a thickness direction of the first substrate; and a first submodule and a second submodule positioned side by side in a first direction intersecting the thickness direction between the first substrate and the second substrate. Each of the first submodule and the second submodule has a base member and a solar cell disposed on the base member. The solar cell has a first electrode layer stacked on the base member, a semiconductor layer stacked on the first electrode layer, and a second electrode layer stacked on the semiconductor layer. The first submodule and the second submodule have different dimensions in at least one of the first direction or a second direction intersecting both the thickness direction and the first direction.
(12) In the power generation module of (11), the first submodule and the second submodule have different dimensions in the first direction.
(13) In the power generation module of (11) or (12), the first submodule and the second submodule have different dimensions in the second direction.
(14) In the power generation module of (13), the solar cells include a first solar cell disposed in the first submodule and a second solar cell disposed in the second submodule. Each of the first solar cell and the second solar cell has one solar cell element or a plurality of solar cell elements electrically connected in series. The first solar cell and the second solar cell have the same number of solar cell elements.
(15) In the power generation module of (13) or (14), it further includes a first lead wire and a second lead wire that electrically connect the solar cells to one other in parallel between the first submodule and the second submodule. Each of the first submodule and the second submodule has a first end in the second direction and a second end located opposite to the first end. The first lead wire is connected to the first electrode layer or the second electrode layer at the first end of each of the first submodule and the second submodule. The second lead wire is connected to the first electrode layer or the second electrode layer at the second end of each of the first submodule and the second submodule. At least one of the first lead wire or the second lead wire extends in the first direction in the first submodule and the second submodule and is bent in the second direction outside the first and second submodules.
(16) In the power generation module of any one of (13) to (15), the dimension of the first submodule in the second direction is equal to or less than twice the dimension of the second submodule in the second direction.
(17) In the power generation module of (11) to (16), the first substrate and the second substrate have a shape extending in the first direction.
(18) In the power generation module of any one of (11) to (17), each of the first submodule and the second submodule has the base member and a plurality of solar cells disposed on a main surface of the base member. Each of the plurality of solar cells extends from one end side to the other end side of the base member in plan view seen along the thickness direction, the plurality of solar cells each having a structure, a plurality of solar cell elements being connected in series in the structure. The plurality of solar cells are arranged at intervals in an intersection direction intersecting with an extension direction of the plurality of solar cells in each of the first submodule and the second submodule. Each of the first submodule and the second submodule has a region between adjacent solar cells in the plan view. The semiconductor layer disposed in each of the plurality of solar cells is apart from the semiconductor layer disposed in a solar cell adjacent thereto via the region.
(19) A method for manufacturing a power generation module includes: preparing a plurality of submodules including a first submodule having a light-transmitting property and a second submodule having a light-transmitting property; preparing a first substrate having a light-transmitting property and having one main surface including an arrangement region where the plurality of submodules are arranged and a non-arrangement region where the plurality of submodules are absent; preparing a second substrate having a light-transmitting property; arranging the first submodule and the second submodule side by side in a first direction intersecting a thickness direction of the first substrate in the arrangement region, the second submodule having different dimensions in at least one of the first direction or a second direction intersecting both the thickness direction and the first direction; and disposing the second substrate facing the first substrate in the thickness direction, the first submodule and the second submodule being positioned between the second substrate and the first substrate. Each of the plurality of submodules has a base member and a solar cell disposed on the base member. The solar cell has a first electrode layer stacked on the base member, a semiconductor layer stacked on the first electrode layer, and a second electrode layer stacked on the semiconductor layer.
(20) In the method of (19), the non-arrangement region has a rectangular shape in plan view seen along the thickness direction. In the plan view, the area of the non-arrangement region is larger than the area of the smallest submodule among the plurality of submodules.
(21) A method for manufacturing a power generation module includes: preparing a first substrate having a light-transmitting property and having an L-shape or a T-shape; preparing a second substrate having a light-transmitting property; preparing a first submodule and a second submodule, each of the first submodule and the second submodule having a base member and a solar cell disposed on the base member; arranging the first submodule and the second submodule densely on one main surface of the first substrate, the first submodule and the second submodule being aligned in a first direction intersecting a thickness direction of the first substrate, the second submodule having different dimensions in at least one of the first direction or a second direction intersecting both the thickness direction and the first direction; and disposing the second substrate facing first substrate in the thickness direction, the first submodule and the second submodule being positioned between the second substrate and the first substrate. The solar cell has a first electrode layer stacked on the base member, a semiconductor layer stacked on the first electrode layer, and a second electrode layer stacked on the semiconductor layer.
(22) In the method of any one of (19) to (21), the solar cell disposed in the first submodule and the solar cell disposed in the second submodule have the same number of solar cell elements.

### INDUSTRIAL APPLICABILITY

The present disclosure is applicable to power generation modules used in building-integrated photovoltaic power generation.

### REFERENCE SIGNS LIST

1, 1A to 1F power generation module
10, 10A first substrate
20, 20A second substrate
30, 301 to 303, 30A to 30C submodule
31 first end
32 second end
40 base member
50, 50A solar cell
51 first electrode layer
511 first extension
512 second extension
52 semiconductor layer
53 second electrode layer
71, 71A first lead wire
72, 72A second lead wire
701 copper wire
702 solder layer

## Claims

1. A power generation module comprising:
a first substrate having a light-transmitting property;
a second substrate having a light-transmitting property, the second substrate facing the first substrate in a thickness direction of the first substrate; and
a plurality of submodules positioned side by side in a direction intersecting the thickness direction between the first substrate and the second substrate, wherein:
each submodule has a base member and a solar cell disposed on the base member; and
the solar cell has a first electrode layer stacked on the base member, a semiconductor layer stacked on the first electrode layer, and a second electrode layer stacked on the semiconductor layer.

2. The power generation module according to claim 1, further comprising:
a first lead wire and a second lead wire that electrically connect the solar cells to one another in parallel among the plurality of submodules, wherein:
the plurality of submodules are aligned in a row in plan view seen along the thickness direction;
each submodule has a first end in a transverse direction intersecting both the thickness direction and the alignment direction of the plurality of submodules, and a second end located opposite to the first end;
the first lead wire is connected to the first electrode layer or the second electrode layer at the first end of each submodule; and
the second lead wire is connected to the first electrode layer or the second electrode layer at the second end of each submodule.

3. The power generation module according to claim 2, wherein
each of the first lead wire and the second lead wire connects the first electrode layers disposed in the plurality of submodules to one another.

4. The power generation module according to claim 3, wherein:
the first electrode layer has an extension that protrudes from the semiconductor layer in a transverse direction intersecting both the thickness direction and the alignment direction in the plan view; and
each of the first lead wire and the second lead wire is connected to the extension.

5. The power generation module according to claim 1, wherein
the plurality of submodules are aligned in two directions intersecting one another in plan view seen along the thickness direction.

6. The power generation module according to claim 1, further comprising:
a first lead wire and a second lead wire that are connected to the first electrode layer or the second electrode layer in each submodule, the first lead wire and the second lead wire electrically connecting the solar cells to one another in parallel among the plurality of submodules, wherein:
each of the first lead wire and the second lead wire includes a copper wire and a solder layer covering the copper wire; and
the solder layer constitutes the outermost layer of each of the first lead wire and the second lead wire.

7. The power generation module according to claim 1, wherein
the base member is a glass plate.

8. The power generation module according to claim 1, wherein
the semiconductor layer comprises a perovskite material.

9. The power generation module according to any one of claims 1 to 8, wherein:
each of the plurality of submodules has the base member and a plurality of solar cells disposed on a main surface of the base member;
each of the plurality of solar cells extends from one end to the other end of the base member in plan view seen along the thickness direction, the plurality of solar cells each having a structure, a plurality of solar cell elements being connected in series in the structure;
the plurality of solar cells are arranged at intervals in an intersection direction intersecting with an extension direction of the plurality of solar cells in each of the plurality of submodules;
each of the plurality of submodules has a region between adjacent solar cells in the plan view; and
the semiconductor layer disposed in each of the plurality of solar cells is apart from the semiconductor layer disposed in a solar cell adjacent thereto via the region.

10. A method for manufacturing a power generation module, comprising:
preparing a first substrate and a second substrate, each of the first substrate and the second substrate having a light-transmitting property;
preparing a plurality of submodules each having a base member and a solar cell disposed on the base member;
arranging the plurality of submodules side by side on the first substrate in a direction intersecting a thickness direction of the first substrate; and
disposing the second substrate facing the first substrate in the thickness direction, the plurality of submodules being positioned between the second substrate and the first substrate, wherein
the solar cell has a first electrode layer stacked on the base member, a semiconductor layer stacked on the first electrode layer, and a second electrode layer stacked on the semiconductor layer.

11. A power generation module comprising:
a first substrate having a light-transmitting property;
a second substrate having a light-transmitting property, the second substrate facing the first substrate in a thickness direction of the first substrate; and
a first submodule and a second submodule positioned side by side in a first direction intersecting the thickness direction between the first substrate and the second substrate, wherein:
each of the first submodule and the second submodule has a base member and a solar cell disposed on the base member;
the solar cell has a first electrode layer stacked on the base member, a semiconductor layer stacked on the first electrode layer, and a second electrode layer stacked on the semiconductor layer; and
the first submodule and the second submodule have different dimensions in at least one of the first direction or a second direction intersecting both the thickness direction and the first direction.

12. The power generation module according to claim 11, wherein
the first submodule and the second submodule have different dimensions in the first direction.

13. The power generation module according to claim 11 or 12, wherein
the first submodule and the second submodule have different dimensions in the second direction.

14. The power generation module according to claim 13, wherein:
the solar cells include a first solar cell disposed in the first submodule and a second solar cell disposed in the second submodule;
each of the first solar cell and the second solar cell has one solar cell element or a plurality of solar cell elements electrically connected in series; and
the first solar cell and the second solar cell have the same number of solar cell elements.

15. The power generation module according to claim 13 or 14, further comprising:
a first lead wire and a second lead wire that electrically connect the solar cells to one another in parallel between the first submodule and the second submodule, wherein:
each of the first submodule and the second submodule has a first end in the second direction and a second end located opposite to the first end;
the first lead wire is connected to the first electrode layer or the second electrode layer at the first end of each of the first submodule and the second submodule;
the second lead wire is connected to the first electrode layer or the second electrode layer at the second end of each of the first submodule and the second submodule; and
at least one of the first lead wire or the second lead wire extends in the first direction in the first submodule and the second submodule and is bent in the second direction outside the first submodule and the second submodule.

16. The power generation module according to any one of claims 13 to 15, wherein
the dimension of the first submodule in the second direction is equal to or less than twice the dimension of the second submodule in the second direction.

17. The power generation module according to any one of claims 11 to 16, wherein
the first substrate and the second substrate have a shape extending in the first direction.

18. The power generation module according to any one of claims 11 to 17, wherein
each of the first submodule and the second submodule has the base member and a plurality of solar cells disposed on a main surface of the base member;
each of the plurality of solar cells extends from one end side to the other end side of the base member in plan view seen along the thickness direction, the plurality of solar cells each having a structure, a plurality of solar cell elements being connected in series in the structure;
the plurality of solar cells are arranged at intervals in an intersection direction intersecting with an extension direction of the plurality of solar cells in each of the first submodule and the second submodule;
each of the first submodule and the second submodule has a region between adjacent solar cells in the plan view; and
the semiconductor layer disposed in each of the plurality of solar cells is apart from the semiconductor layer disposed in a solar cell adjacent thereto via the region.

19. A method for manufacturing a power generation module, comprising:
preparing a plurality of submodules including a first submodule having a light-transmitting property and a second submodule having a light-transmitting property;
preparing a first substrate having a light-transmitting property and having one main surface including an arrangement region where the plurality of submodules are arranged and a non-arrangement region where the plurality of submodules are absent;
preparing a second substrate having a light-transmitting property;
arranging the first submodule and the second submodule side by side in a first direction intersecting a thickness direction of the first substrate in the arrangement region, the second submodule having different dimensions in at least one of the first direction or a second direction intersecting both the thickness direction and the first direction; and
disposing the second substrate facing the first substrate in the thickness direction, the first submodule and the second submodule being positioned between the second substrate and the first substrate, wherein:
each of the plurality of submodules has a base member and a solar cell disposed on the base member; and
the solar cell has a first electrode layer stacked on the base member, a semiconductor layer stacked on the first electrode layer, and a second electrode layer stacked on the semiconductor layer.

20. The method according to claim 19, wherein:
the non-arrangement region has a rectangular shape in plan view seen along the thickness direction; and
in the plan view, the area of the non-arrangement region is larger than the area of the smallest submodule among the plurality of submodules.

21. A method for manufacturing a power generation module, comprising:
preparing a first substrate having a light-transmitting property and having an L-shape or a T-shape;
preparing a second substrate having a light-transmitting property;
preparing a first submodule and a second submodule, each of the first submodule and the second submodule having a base member and a solar cell disposed on the base member;
arranging the first submodule and the second submodule densely on one main surface of the first substrate, the first submodule and the second submodule being aligned in a first direction intersecting a thickness direction of the first substrate, the second submodule having different dimensions in at least one of the first direction or a second direction intersecting both the thickness direction and the first direction; and
disposing the second substrate facing first substrate in the thickness direction, the first submodule and the second submodule being positioned between the second substrate and the first substrate, wherein
the solar cell has a first electrode layer stacked on the base member, a semiconductor layer stacked on the first electrode layer, and a second electrode layer stacked on the semiconductor layer.

22. The method according to any one of claims 19 to 21, wherein
the solar cell disposed in the first submodule and the solar cell disposed in the second submodule have the same number of solar cell elements.
